# FASCICULE DE BREVET EUROPEEN

(11) **EP 3 991 528 B1**
(45) Date de publication et mention de la délivrance du brevet: **25.09.2024**
(21) Numéro de dépôt: 20734044.9
(22) Date de dépôt: 25.06.2020
(51) Int. Cl.: H05K 7/20

(54) **SYSTÈME ÉLECTRONIQUE ET CONVERTISSEUR DE TENSION COMPRENANT UN TEL SYSTÈME ÉLECTRONIQUE**
ELEKTRONISCHES SYSTEM UND SPANNUNGSWANDLER MIT EINEM SOLCHEN ELEKTRONISCHEN SYSTEM
ELECTRONIC SYSTEM AND VOLTAGE CONVERTER COMPRISING SUCH AN ELECTRONIC SYSTEM

(30) Priorité: 28.06.2019 FR 1907201
(43) Date de publication de la demande: 04.05.2022
(73) Titulaire: Valeo Electrification, 95800 Cergy (FR)
(72) Inventeur: FALCHI, Danilo, 95892 CERGY PONTOISE Cedex (FR)
(74) Mandataire: Valeo Powertrain Systems
(86) Numéro de dépôt international: PCT/EP2020/067831
(87) Numéro de publication internationale: WO 2020/260465

(56) Documents cités:
- EP-A2- 2 844 052
- US-A1- 2012 180 993
- US-B1- 6 209 631

## Description

La présente invention concerne de manière générale les systèmes électroniques pour véhicule automobile électriques ou hybrides et qui comporte un dispositif de refroidissement. Elle concerne également un convertisseur de tension comportant un tel système électronique.

Les convertisseurs de tension mis en oeuvre dans le domaine automobile comportent des composants de puissance implantés sur une carte électronique. Ces composants de puissance sont en fonctionnement traversés par des courants importants, par exemple de plusieurs centaines d'ampères, ce qui génère un échauffement très important de ces composants, pouvant s'ils ne sont pas refroidis les endommager de façon irréversible.

Il convient donc de refroidir ces composants de puissance lors de leur utilisation.

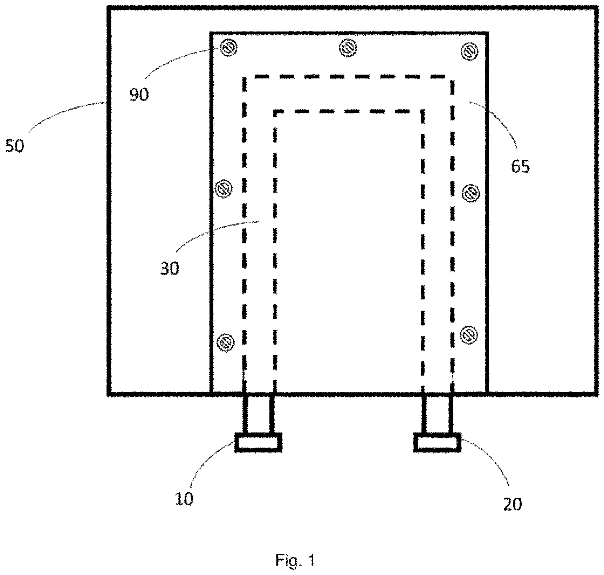

Pour ce faire, on connait de l'art antérieur un système électronique comportant des composants électroniques placés en contact thermique avec le fond d'un boitier 50. Comme décrit sur la figure 1, le fond du boitier comprend dans son épaisseur un embout d'entrée 10, un embout de sortie 20 et un canal de refroidissement 30, un fluide de refroidissement, par exemple de l'éthylène glycol, circulant dans le canal de refroidissement 30 de l'embout d'entrée 10 vers l'embout de sortie 20 de manière à refroidir les composants électroniques. Le canal de refroidissement est réalisé sous forme d'une cavité creusée dans le fond du boitier, ladite cavité étant fermé au moyen d'un couvercle 65 et d'un joint d'étanchéité 60 (non représenté sur la figure) placé entre la cavité et le couvercle 65. Des vis 90 assurent le maintien de l'assemblage du couvercle 65 et du joint d'étanchéité 60 avec le boitier 50.

Cependant, l'étanchéité d'un tel système de refroidissement est difficile à mettre en oeuvre.

L'invention a pour but de pallier au moins en partie à ce problème.

Le document EP 2 844 052 A2 divulgue par ailleurs un système électronique selon le préambule de la revendication 1.

A cet effet il est proposé selon un premier aspect, un système électronique comprenant :
a. un boitier comprenant un fond et au moins une première paroi,
b. un premier radiateur et un premier ventilateur fixés à l'extérieur dudit boitier sur ladite première paroi, ledit premier ventilateur étant fixé sur ladite première paroi, de façon à refroidir ledit premier radiateur,
c. un premier caloduc destiné à être en contact thermique avec un premier composant électronique, une extrémité dudit premier caloduc traversant ladite première paroi et au moins une partie dudit premier radiateur
d. un premier conduit compris dans ledit fond ou disposé sur une face intérieure dudit fond,
e. ledit premier caloduc étant au moins partiellement disposé dans ledit premier conduit.

Ainsi l'utilisation d'un système électronique selon l'invention permet de refroidir des composants électroniques sans utiliser un canal de refroidissement formé par une cavité dans le fond du boitier et fermée par un couvercle, ce qui permet d'éviter un système d'assemblage et d'étanchéité complexe à mettre en oeuvre du système électronique.

Le système électronique selon le premier aspect de l'invention peut également présenter une ou plusieurs des caractéristiques des modes particuliers de réalisation ci-dessous, considérées individuellement ou selon toutes les combinaisons techniquement possibles.

Dans un mode particulier de réalisation de de l'invention, ledit premier conduit est compris dans le fond, ledit premier conduit comprenant une cavité formée sur une face extérieure dudit fond.

Dans un mode particulier de réalisation de de l'invention, la cavité a une forme de rainure.

Dans un mode particulier de réalisation de de l'invention, la cavité est une rainure.

Dans un mode particulier de réalisation de de l'invention, l'intérieur du premier conduit à une forme tubulaire et sa section est de forme circulaire ou de forme sensiblement rectangulaire ou encore de forme au moins partiellement elliptique.

Dans un mode particulier de réalisation de de l'invention, le système électronique comprend en outre le premier composant électronique, le premier composant électronique est en contact thermique avec le premier caloduc et ledit premier composant électronique est en outre, par l'intermédiaire d'une pâte thermique électriquement isolante, en contact thermique avec le premier conduit.

Dans un mode particulier de réalisation de de l'invention, ledit boitier est hermétiquement clôt et l'intérieur dudit premier conduit est hermétiquement séparé de l'intérieur dudit boitier.

Dans un mode particulier de réalisation de de l'invention, ledit boitier comprend en outre une deuxième paroi, ledit système électronique comprenant en outre :
a. un deuxième radiateur et un deuxième ventilateur fixés à l'extérieur dudit boitier sur ladite deuxième paroi, ledit deuxième ventilateur étant fixé sur ladite deuxième paroi de façon à refroidir ledit deuxième radiateur,
b. un deuxième caloduc destiné à être en contact thermique avec un deuxième composant électronique, une extrémité dudit deuxième caloduc traversant ladite deuxième paroi et au moins une partie dudit deuxième radiateur,
c. un deuxième conduit compris dans ledit fond ou disposé sur une face extérieure dudit fond
d. ledit deuxième caloduc étant au moins partiellement disposé dans ledit deuxième conduit.

Dans un mode particulier de réalisation de de l'invention, le premier et le deuxième conduit forme un seul conduit.

Dans un mode particulier de réalisation de de l'invention, le premier et/ou le deuxième conduit est de forme rectiligne.

Dans un mode particulier de réalisation de l'invention, ledit premier ventilateur est un ventilateur axial ou un ventilateur radial ou encore un ventilateur tangentiel.

Dans un mode particulier de réalisation de l'invention, ledit deuxième ventilateur est un ventilateur axial ou un ventilateur radial ou encore un ventilateur tangentiel.

Dans un mode particulier de réalisation de l'invention, ledit premier conduit comprend au moins une première ouverture, ladite première ouverture étant réalisée à travers une paroi du premier conduit, ledit premier composant électronique étant destiné à être au moins partiellement disposé dans ladite au moins une première ouverture afin d'être en contact thermique directement ou par l'intermédiaire seulement d'une pâte thermique avec le premier caloduc.

Dans un mode particulier de réalisation de l'invention, ledit deuxième conduit comprend au moins une deuxième ouverture, ladite deuxième ouverture étant réalisée à travers une paroi du deuxième conduit, ledit deuxième composant électronique étant destiné à être au moins partiellement disposé dans ladite au moins une deuxième ouverture afin d'être en contact thermique directement ou par l'intermédiaire seulement d'une pâte thermique avec le deuxième caloduc.

L'invention vise également, selon un deuxième aspect un convertisseur de tension comprenant :
a. Un système électronique selon le premier aspect de l'invention
b. Un interrupteur électronique par exemple un thyristor, une diode un transistor bipolaire, un transistor MOSFET, ou un transistor IGBT ledit premier composant électronique à refroidir étant ledit interrupteur électronique

De façon optionnelle le convertisseur de tension est un convertisseur de tension continu-continu ou un convertisseur de tension alternative-continu ou encore un convertisseur de tension continu-alternative

### Brève description des dessins :

[Fig.1] représente la face extérieure du fond d'un boitier d'un système électronique selon l'art antérieur.
[Fig.2] représente l'intérieur d'un boitier d'un système électronique dans un premier mode de réalisation de l'invention.
[Fig.3] représente la face extérieure du fond d'un boitier d'un système électronique dans un premier mode de réalisation de l'invention.
[Fig.4] représente l'intérieur d'un boitier d'un système électronique dans un deuxième mode de réalisation de l'invention.
[Fig.5] représente la face extérieure du fond d'un boitier d'un système électronique dans un deuxième mode de réalisation de l'invention.
[Fig.6] représente l'intérieur d'un boitier d'un système électronique dans un troisième mode de réalisation de l'invention.
[Fig.7] représente l'intérieur d'un boitier d'un système électronique dans un quatrième mode de réalisation de l'invention.
[Fig.8] représente la face extérieure du fond d'un boitier d'un système électronique dans un quatrième mode de réalisation de l'invention.
[Fig.9] représente l'intérieur d'un boitier d'un système électronique dans un cinquième mode de réalisation de l'invention.
[Fig.10] représente la face extérieure du fond d'un boitier d'un système électronique dans un cinquième mode de réalisation de l'invention.
[Fig. 11] représente l'intérieure d'un boitier d'un système électronique dans une première variante du premier mode de réalisation de l'invention.
[Fig 12] représente l'intérieure d'un boitier d'un système électronique dans une deuxième variante du premier mode de réalisation de l'invention.

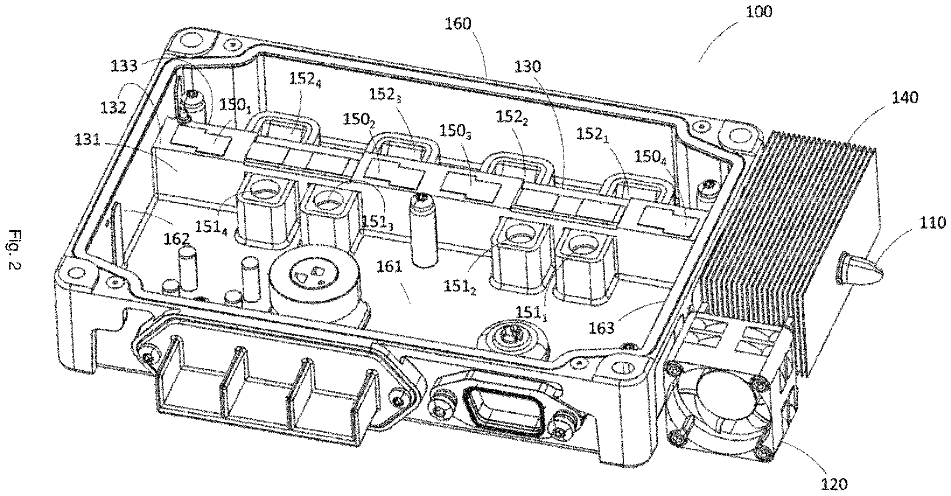

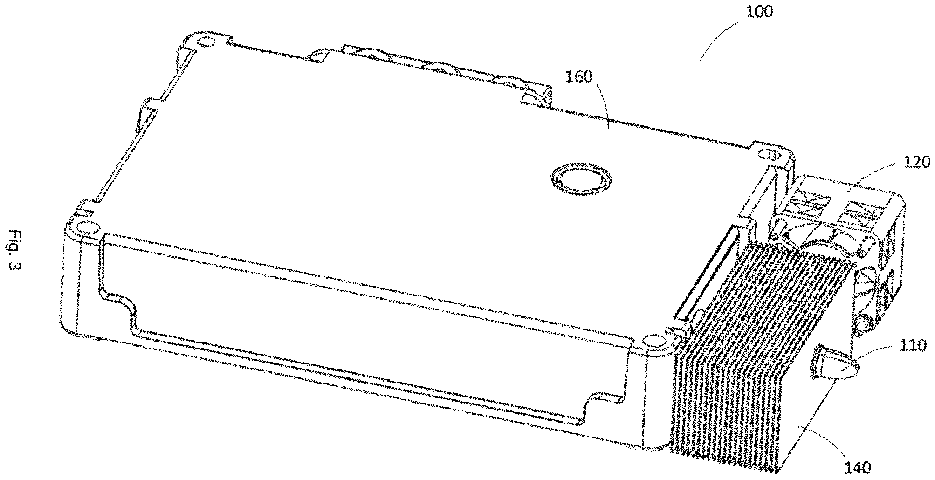

En référence aux figures 2 et 3, un convertisseur de tension 100 selon un premier mode de réalisation de l'invention va être décrit. Le convertisseur de tension 100 est par exemple utilisé dans un véhicule automobile.

Le convertisseur de tension 100 comprend un système électronique. Ce système électronique comprend un boitier 160, au moins un premier et un deuxième composant électronique 170, 171 (non représentés sur les figures) à refroidir et placés à l'intérieur du boitier 160, un premier radiateur 140, un premier ventilateur 120 et un premier caloduc 110.

Le premier composant électronique 170 est par exemple un interrupteur électronique tel qu'un MOSFET ou un IGBT faisant partie d'un bras de commutation du convertisseur de tension 100.

Le deuxième composant électronique 171 est par exemple une inductance. On notera que dans l'exemple décrit ici, le premier composant électronique 170 dissipe en fonctionnement plus de chaleur que le deuxième composant électronique 171.

Le premier caloduc 110 se présente sous la forme d'un tube fermé de section circulaire, par exemple en cuivre, dans lequel un fluide caloporteur circule. Ce fluide caloporteur est de préférence un fluide bi-phasique qui peut être de l'acétone, de l'ammoniac, du méthanol, du toluène ou encore de l'eau. De façon connu, le premier caloduc 110 comprend une première extrémité où le fluide se vaporise en absorbant de l'énergie thermique et une deuxième extrémité où le fluide se condense pour retourner à l'état liquide, la circulation du fluide au sein du premier caloduc 110 se faisant par exemple par capillarité.

Dans l'exemple décrit, le boitier 160 est un parallélépipède rectangle comprenant un fond 161 entouré d'une première 163, d'une deuxième 162, d'une troisième et d'une quatrième paroi. La longueur de la première et deuxième paroi définit la largeur du boitier, et la longueur de la troisième et quatrième paroi définit la longueur du boitier. Le fond 161 et les quatre parois du boitier 161 définissent en outre un logement intérieur du boitier.

Dans l'exemple décrit, le boitier 160 est un boitier métallique, par exemple en aluminium.

Dans l'exemple décrit ici, le fond 161 comprend en outre un premier conduit 130 qui forme une excroissance par rapport au reste de la surface sensiblement plane du fond 261. Cette excroissance à une forme parallélépipédique qui s'étend entre la première 163 et la deuxième paroi 162 du boitier 160. L'intérieur du premier conduit 130 est usiné à partir de la première paroi 163 sans traverser la deuxième paroi 162. Un tel usinage réalise une ouverture dans la première paroi 163 au travers de laquelle l'intérieur du premier conduit 130 débouche sur l'extérieur du boitier 160.

En variante, le premier conduit 130 à une forme parallélépipédique et est disposé sur la face intérieure du fond 161 du boitier 160. En d'autres termes, le premier conduit 130 n'est pas réalisé en continuité de matière avec le boitier 160 mais il est réalisé indépendamment du fond 161 et fixé sur ce fond 161 de façon à être placé entre la première et la deuxième paroi 163, 162 et en contact avec celles-ci. Dans cette variante de réalisation, la première paroi 163 comporte une ouverture qui se trouve placée, après assemblage du premier conduit 130 sur le boitier 160, en vis-à-vis de l'intérieure du premier conduit 130 de sorte que l'intérieur du premier conduit 130 débouche par cette ouverture sur l'extérieur du boitier 160.

Dans l'exemple décrit ici, l'intérieur du premier conduit 130 à une forme tubulaire creuse dont la section est de forme sensiblement circulaire. En variante, la section de la forme tubulaire creuse peut être sensiblement rectangulaire.

En outre, la section de la forme tubulaire creuse est suffisamment importante pour permettre l'introduction en son sein de la première extrémité du premier caloduc 110.

L'intérieur du premier conduit 130 est obstrué au moins par la deuxième paroi 162 du boitier 160 mais débouche sur l'extérieur du boitier au niveau de la première paroi 163 dudit boitier.

En outre, dans l'exemple décrit ici, le premier conduit 130 présente trois faces rectangulaires extérieures 131, 132, 133 accessibles depuis le logement intérieur du boitier 160. Les deux faces rectangulaires 131, 133 sont parallèles à la troisième et à la quatrième paroi du boitier 160 tandis que la face rectangulaire 132 est parallèle au fond 161 du boitier 160. En variante, le premier conduit peut présenter seulement deux faces extérieures, voire une seule face extérieure, accessibles depuis le logement intérieur du boitier 160.

Les trois faces rectangulaires 131, 132, 133 présentent des zones de réceptions 150₁, 150₂, 150₃, 150₄, 151₁, 151₂, 151₃, 151₄, 152₁, 152₂, 152₃, 152₄ en contact avec des composants électroniques du convertisseur de tension 100.

Les zones de réception 151₁, 151₂, 151₃, 151₄, 152₁, 152₂, 152₃, 152₄ sont constituées de cavités de réception de composants électronique, chacune desdites cavités étant réalisées dans une excroissance faisant saillie à partir des faces rectangulaires 131, 133 du premier conduit 130.

Dans l'exemple décrit ici, les ouvertures des cavités des zones de réception 151₁, 151₂, 151₃, 151₄, 152₁, 152₂, 152₃, 152₄ sont parallèles au fond 161 du boitier 160.

Les zones de réception 150₁, 150₂, 150₃, 150₄ font parties de la surface extérieure de la face rectangulaire 132.

Dans l'exemple décrit ici, le premier composant électronique 170 est placé en contact de l'une des zones de réception 150₁, 150₂, 150₃, 150₄ par l'intermédiaire d'une pâte thermique et le deuxième composant électronique 171 est inséré dans une cavité d'une zone de réception 151₁, 151₂, 151₃, 151₄, le contact entre le deuxième composant électronique 171 et une partie de ladite cavité s'effectuant également au moyen d'une pâte thermique.

De façon préférentielle, le premier composant électronique 170 qui dissipe plus de chaleur que le deuxième composant électronique 171 est placé dans une zone de réception 150₁, 150₂, 150₃, 150₄ qui est plus éloignée de la deuxième paroi 163 que ne l'est la zone de réception 151₁, 151₂, 151₃, 151₄ où est placé le deuxième composant électronique 171.

Le premier radiateur 140 est composé d'un empilage d'ailettes métalliques de forme rectangulaire. Les ailettes métalliques sont séparées par un espace pour permettre le passage d'un flux d'air entre elles.

Le premier radiateur 140 et le premier ventilateur 120 sont fixés à l'extérieur du boitier 160, i.e. à l'extérieur du logement intérieur du boitier 160, sur la première paroi 163. Le premier ventilateur 120 est en outre fixé sur la première paroi 163 de façon à refroidir le premier radiateur 140. En d'autres termes, Le premier ventilateur 120 et le premier radiateur 140 sont fixés sur la première paroi 163 de sorte que les ailettes métalliques du premier radiateur 140 soient parallèles à la première paroi 163 et que le premier ventilateur, lorsqu'il est en fonctionnement, génère un flux d'air passant entre lesdites ailettes métalliques permettant ainsi leur refroidissement.

Dans l'exemple décrit ici, le premier ventilateur 120 est un ventilateur axial. En variante, le premier ventilateur 120 peut être un ventilateur radial ou tangentiel.

En outre, chacune des ailettes métalliques du premier radiateur 140 comprend une ouverture, ces ouvertures étant suffisamment larges et positionnées en regard les unes des autres de façon à permettre l'introduction, depuis l'extérieur du boitier 160, d'une extrémité du premier caloduc 110 dans la section de forme tubulaire creuse du premier conduit 130.

Ainsi, le premier caloduc 110 traverse, avant son introduction dans la section de forme tubulaire creuse du premier conduit 130, les ailettes métalliques du premier radiateur 140 et la première paroi 163 du boitier 160.

Après son introduction, le premier caloduc 110 est disposé dans le premier conduit 130 de sorte que sa première extrémité est en contact thermique avec les zones de réception 150₁, 150₂, 150₃, 150₄, 151₁, 151₂, 151₃, 151₄, 152₁, 152₂, 152₃, 152₄ et de sorte que sa deuxième extrémité est en contact thermique avec les ailettes métalliques du premier radiateur 140. Ainsi, dans ce premier mode de réalisation de l'invention, le premier caloduc pénètre jusqu'au fond du premier conduit 130.

Le premier caloduc 110 peut optionnellement être fixé au premier radiateur 140 par sertissage.

Lorsque le convertisseur de tension 100 est en marche, les premier et deuxième composants électroniques 170, 171 s'échauffent et leur température augmente. L'énergie thermique dissipée par les composants électroniques 170, 171 en fonctionnement est alors drainée vers les zones de réception du premier conduit 130 par l'intermédiaire de la pâte thermique, puis du premier conduit 130 vers la première extrémité du premier caloduc 110. Au niveau de cette première extrémité, le fluide caloporteur du premier caloduc 110 se vaporise en absorbant l'énergie thermique émise par les premier et deuxième composants électroniques 170, 171. La vapeur circule alors dans le premier caloduc 110 jusqu'à sa deuxième extrémité située au niveau des ailettes métalliques du premier radiateur 140 où elle se condense pour retourner à l'état liquide. Durant la phase de condensation l'énergie thermique est transmise du premier caloduc au premier radiateur 140 refroidi par le premier ventilateur 120.

En outre et de façon optionnelle, le boitier 160 peut être hermétiquement clos. Et dans ce cas le boitier 160 comprend un couvercle et des moyens d'étanchéité. Ces moyens d'étanchéité comprennent par exemple un joint d'étanchéité entre le boitier 160 et son couvercle, et dans le cas où le premier conduit 130 est disposé sur la face intérieure du fond du boitier 161 du boitier 160 des joints d'étanchéité additionnels sont disposés entre les première et deuxième parois 163,162 et le boitier 160. L'intérieur du boitier 160 et l'intérieur du premier conduit 130 sont hermétiquement séparés, en d'autres termes il n'existe pas d'ouverture dans le premier conduit 130 débouchant sur l'intérieur du boitier 160

Ainsi, le premier caloduc 110, le premier conduit 130, le premier radiateur 140 et le premier ventilateur 120 constitue un dispositif de refroidissement des premier et deuxième composants électroniques 170, 171.

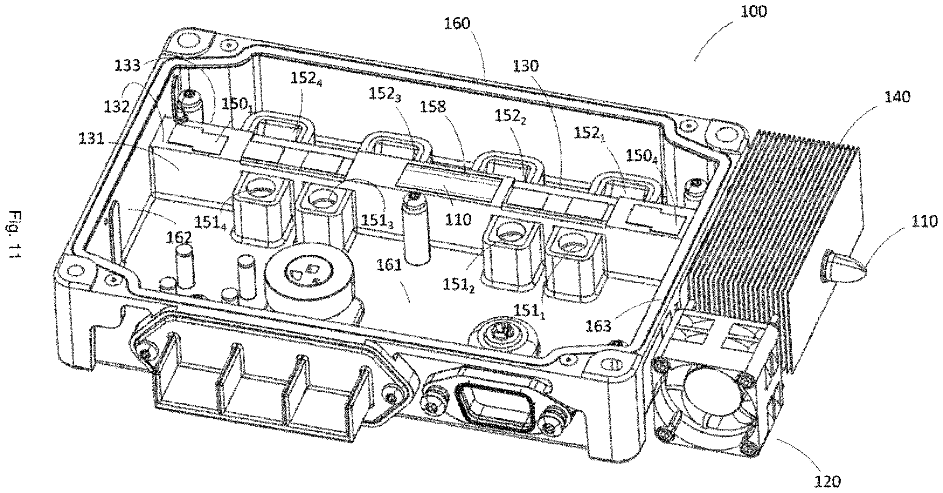

Dans une première variante du premier mode de réalisation de l'invention représentée à la figure 11, le premier conduit 130 présente une première ouverture 158 sur la face rectangulaire 132. La première ouverture 158 est réalisée en lieu et place des zones de réception 150₂ et 150₃. La première ouverture 158 traverse la face rectangulaire 132 du premier conduit 130 et débouche sur l'intérieur du boitier 160. Ainsi, lorsque le premier composant électronique 170 est introduit au moins partiellement dans la première ouverture 158, le premier composant électronique 170 est en contact direct ou par l'intermédiaire seulement d'une pâte thermique avec le premier caloduc 110. De cette façon, le contact thermique entre le premier composant électronique 170 et le premier caloduc 110 est amélioré puisque ce contact thermique ne se fait plus par l'intermédiaire de la face rectangulaire 152.

En variante, la première ouverture 158 peut également être réalisée dans les face rectangulaires 131, 133 à côté ou en lieu et place des zones de réception 151₁ à 151₄ et 152₁ à 152₄.

Le premier caloduc 110 peut présenter une section circulaire ou une section semi-circulaire. En outre et de façon optionnelle, lorsque le premier caloduc 110 présente une section semi circulaire, le premier caloduc 110 peut également comporter une surface plane, qui lorsque le premier caloduc 110 est introduit dans le premier conduit 130 est placée en regard de l'intérieur du boitier 160 ce qui permet d'avoir une surface de contact thermique avec le premier composant électronique 170 plus importante que lorsque le premier caloduc 110 présente une section circulaire.

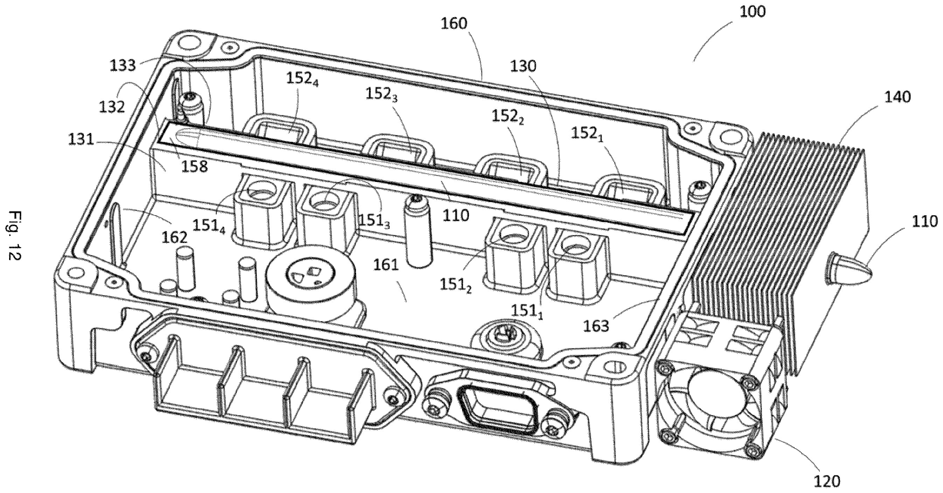

Dans une deuxième variante du premier mode de réalisation de l'invention représentée à la figure 12, le premier conduit 130 présente une première ouverture 158 sur la face rectangulaire 132 qui s'étend de la première paroi 163 à la deuxième paroi 162. Ainsi, la première ouverture 158 est réalisée en lieu et place des zones de réception 150₁, 150₂, 150₃ et 150₄ La première ouverture 158 traverse en outre la face rectangulaire 132 du premier conduit 130 et débouche sur l'intérieur du boitier 160. Ainsi, lorsque le premier composant électronique 170 est introduit au moins partiellement dans la première ouverture 158, le premier composant électronique 170 est en contact direct ou seulement par l'intermédiaire d'une pâte thermique avec le premier caloduc 110. De cette façon, le contact thermique entre le premier composant électronique 170 et le premier caloduc 110 est amélioré puisque ce contact thermique ne se fait plus par l'intermédiaire de la face rectangulaire 152.

Le premier caloduc 110 peut présenter une section circulaire ou une section semi-circulaire. De façon optionnelle, lorsque le premier caloduc 110 présente une section semi circulaire, le premier caloduc 110 peut également comporter une surface plane, qui lorsque le premier caloduc 110 est introduit dans le premier conduit 130 est placée en regard de l'intérieur du boitier 160 ce qui permet d'avoir une surface de contact thermique avec le premier composant électronique 170 plus importante que lorsque le premier caloduc 110 présente une section circulaire.

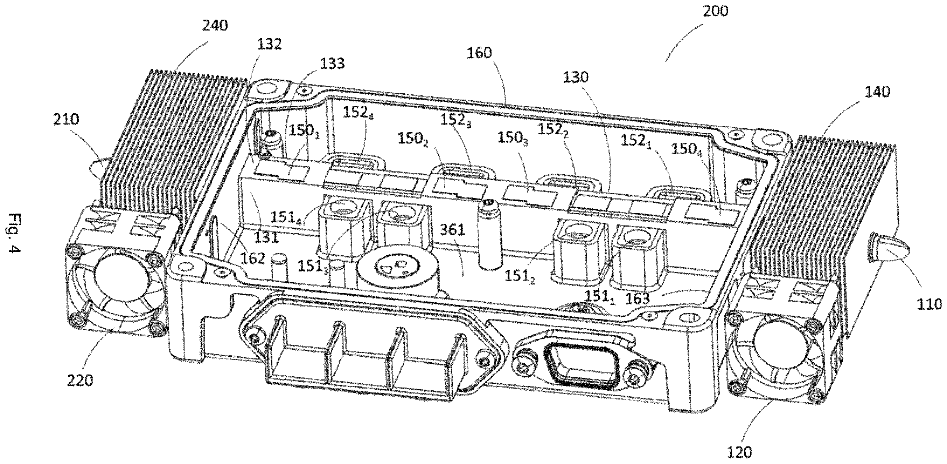

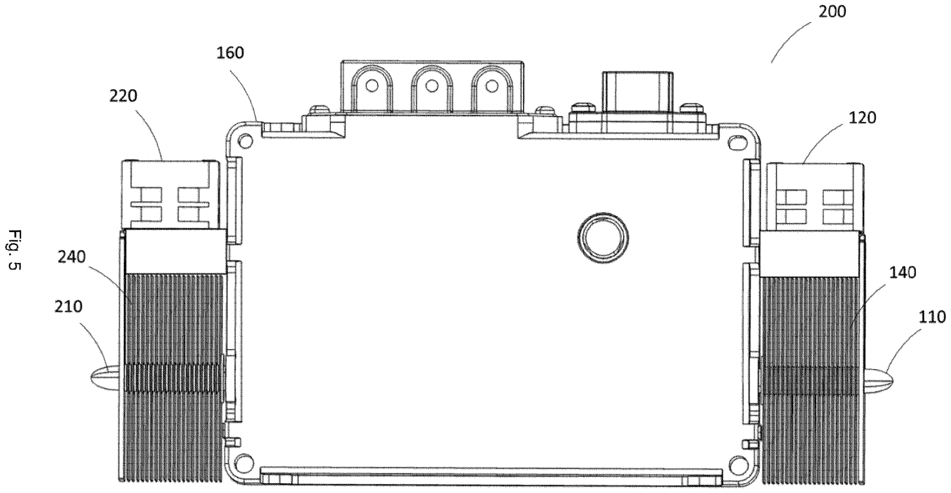

En référence aux figures 4 et 5, un convertisseur de tension 200 selon un deuxième mode de réalisation de l'invention va être maintenant décrit. Les éléments identiques au premier mode de réalisation des figures 2 et 3 gardent les mêmes références et ne seront pas décrits à nouveau.

Le convertisseur de tension 200 diffère du convertisseur de tension 100 précédemment décrit en ce qu'il comprend un troisième et un quatrième composant électronique 172, 173 (non représentés sur les figures), en ce que l'intérieur du premier conduit 130 débouche sur l'extérieur du boitier au niveau de la deuxième paroi 162 dudit boitier et en ce que le système électronique comprend en outre un deuxième radiateur 240, un deuxième ventilateur 220 et un deuxième caloduc 210.

Le troisième composant électronique 172 est par exemple un interrupteur électronique tel qu'un MOSFET ou un IGBT faisant partie d'un bras de commutation du convertisseur de tension 100.

Le quatrième composant électronique 173 est par exemple une inductance. On notera que dans l'exemple décrit ici, le quatrième composant électronique 173 dissipe en fonctionnement plus de chaleur que le troisième composant électronique 172.

Dans l'exemple décrit ici, le premier composant électronique 170 est placé en contact de la zone de réception 150₃ par l'intermédiaire d'une pâte thermique et le deuxième composant électronique 171 est placé en contact de la zone de réception 151₁ par l'intermédiaire d'une pâte thermique. En outre, le troisième composant électronique 172 est placé en contact de la zone de réception 150₂ par l'intermédiaire d'une pâte thermique et le quatrième composant électronique 173 est inséré dans la cavité de la zone de réception 151₄, le contact entre le quatrième composant électronique 173 et une partie de ladite cavité s'effectuant également au moyen d'une pâte thermique.

Le deuxième caloduc 210 se présente sous la forme d'un tube fermé de section circulaire, par exemple en cuivre, dans lequel un fluide caloporteur circule. De façon connu, le deuxième caloduc 210 comprend une première extrémité où le fluide se vaporise en absorbant de l'énergie thermique et une deuxième extrémité où le fluide se condense pour retourner à l'état liquide, la circulation du fluide au sein du deuxième caloduc 210 se faisant par exemple par capillarité.

Le deuxième radiateur 240 est composé d'un empilage d'ailettes métalliques de forme rectangulaire. Les ailettes métalliques sont séparées par un espace pour permettre le passage d'un flux d'air entre elles.

Le deuxième radiateur 240 et le deuxième ventilateur 220 sont fixés à l'extérieur du boitier 160, i.e. à l'extérieur du logement intérieur du boitier 160, sur la deuxième paroi 162. Le deuxième ventilateur 220 est en outre fixé sur la deuxième paroi 162 de façon à refroidir le deuxième radiateur 240. En d'autres termes, Le deuxième ventilateur 220 et le deuxième radiateur 240 sont fixés sur la deuxième paroi 162 de sorte que les ailettes métalliques du deuxième radiateur 240 soient parallèle à la deuxième paroi 162 et que le deuxième ventilateur, lorsqu'il est en fonctionnement, génère un flux d'air passant entre lesdites ailettes métalliques permettant ainsi leur refroidissement.

Dans l'exemple décrit ici, le deuxième ventilateur 220 est un ventilateur axial . En variante, le deuxième ventilateur 220 peut être un ventilateur radial ou tangentiel.

En outre, chacune des ailettes métalliques du deuxième radiateur 240 comprend une ouverture, ces ouvertures étant suffisamment larges et positionnées en regard les unes des autres de façon à permettre l'introduction, depuis l'extérieur du boitier 160, d'une extrémité du deuxième caloduc 210 dans la section de forme tubulaire creuse du premier conduit 130.

Ainsi, le deuxième caloduc 210 traverse, avant son introduction dans la section de forme tubulaire creuse du premier conduit 130, les ailettes métalliques du deuxième radiateur 240 et la deuxième paroi 162 du boitier 160.

Dans ce deuxième mode de réalisation de l'invention, le premier caloduc 110 est disposé dans le premier conduit 130 de sorte que sa première extrémité est en contact thermique avec les zones de réception 150₃, 150₄, 151₁, 151₂, 152₁, 152₂ et de sorte que sa deuxième extrémité est en contact thermique avec les ailettes métalliques du premier radiateur 140. Ainsi, dans ce deuxième mode de réalisation de l'invention, le premier caloduc 110 pénètre seulement jusqu'à la moitié du premier conduit 130.

Après son introduction, le deuxième caloduc 210 est disposé au moins partiellement dans le premier conduit 130 de sorte que sa première extrémité est en contact thermique avec les zones de réception 150₁, 150₂, 151₃, 151₄, 152₃, 152₄ et de sorte que sa deuxième extrémité est en contact thermique avec les ailettes métalliques du deuxième radiateur 240. Ainsi, dans ce deuxième mode de réalisation de l'invention, le deuxième caloduc 210 pénètre seulement jusqu'à la moitié du premier conduit 130.

Le deuxième caloduc 210 peut optionnellement être fixé au deuxième radiateur 240 par sertissage.

Lorsque le convertisseur de tension 200 est en marche, les premier et deuxième composants électroniques 170, 171 s'échauffent et leur température augmente. L'énergie thermique dissipée par les premier et deuxième composants électroniques 170, 171 en fonctionnement est alors drainée vers les zones de réception 150₃, 151₁ du premier conduit 130 par l'intermédiaire de la pâte thermique, puis de ces zones de réception 150₃, 151₁ du premier conduit 130 vers la première extrémité du premier caloduc 110. Au niveau de cette première extrémité, le fluide caloporteur du premier caloduc 110 se vaporise en absorbant l'énergie thermique émise par les premier et deuxième composants électronique 170, 171. La vapeur circule alors dans le premier caloduc 110 jusqu'à sa deuxième extrémité située au niveau des ailettes métalliques du premier radiateur 140 où elle se condense pour retourner à l'état liquide. Durant la phase de condensation l'énergie thermique est transmise du premier caloduc 110 au premier radiateur 140 refroidi par le premier ventilateur 120.

De même, lorsque le convertisseur de tension 200 est en marche, les troisième et quatrième composants électroniques 172, 173 s'échauffent et leur température augmente. L'énergie thermique dissipée par les troisième et quatrième composants électroniques 172, 173 en fonctionnement est alors drainée vers les zones de réception 150₂, 151₄ du premier conduit 130 par l'intermédiaire de la pâte thermique, puis de ces zones de réception 150₂, 151₄ du premier conduit 130 vers la première extrémité du deuxième caloduc 210. Au niveau de cette première extrémité, le fluide caloporteur du deuxième caloduc 210 se vaporise en absorbant l'énergie thermique émise par les troisième et quatrième composants électronique 172, 173. La vapeur circule alors dans le deuxième caloduc 210 jusqu'à sa deuxième extrémité située au niveau des ailettes métalliques du deuxième radiateur 240 où elle se condense pour retourner à l'état liquide. Durant la phase de condensation l'énergie thermique est transmise au deuxième radiateur 240 refroidi par le deuxième ventilateur 220.

Dans une première variante du deuxième mode de réalisation de l'invention non représentée sur les figures, le premier conduit 130 présente une première ouverture 158 sur la face rectangulaire 132. La première ouverture 158 est réalisée en lieu et place des zones de réception 150₂ et 150₃. La première ouverture 158 traverse la face rectangulaire 132 du premier conduit 130 et débouche sur l'intérieur du boitier 160. Ainsi, lorsque le premier composant électronique 170 est introduit au moins partiellement dans la première ouverture 158, le premier composant électronique 170 est en contact direct ou seulement par l'intermédiaire d'une pâte thermique avec le premier caloduc 110. Lorsque le troisième composant électronique 172 est introduit au moins partiellement dans la première ouverture 158, le troisième composant est en contact direct ou seulement par l'intermédiaire d'une pâte thermique avec le deuxième caloduc 210. De cette façon, le contact thermique entre le premier composant électronique 170 et le premier caloduc 110 est amélioré puisque ce contact thermique ne se fait plus par l'intermédiaire de la face rectangulaire 13.2. Le contact thermique entre le troisième composant électronique 172 et le deuxième caloduc 210 est également amélioré puisque ce contact ne se fait plus par l'intermédiaire de la face rectangulaire 132

En variante, la première ouverture 158 peut également être réalisée dans les face rectangulaires 131,133 à côté ou en lieu et place des zones de réception 151₁ à 151₄ et 152₁ à 152₄.

Le premier caloduc 110 et/ ou le deuxième caloduc 210 peuvent présenter une section circulaire ou une section semi-circulaire. De façon optionnelle, lorsque le premier caloduc 110 et/ou le deuxième caloduc 210 présentent une section semi circulaire, le premier et/ou le deuxième caloduc 110,210 peuvent comporter une surface plane, qui lorsque le premier et/ou le deuxième caloduc 110,210 sont introduits dans le premier conduit 130 est placée en regard de l'intérieur du boitier 160 ce qui permet d'avoir une surface de contact thermique avec le premier et/ou le troisième composants électroniques 170, 172 plus importante que lorsque le premier et/ou le deuxième caloduc 110 présentent une section circulaire.

Dans une deuxième variante du deuxième mode de réalisation de l'invention non représentée sur les figure, le premier conduit 130 présente une première ouverture 158 sur la face rectangulaire 132 qui s'étend de la première paroi 163 à la deuxième paroi 162. Ainsi, la première ouverture 158 est réalisée en lieu et place des zones de réception 150₁, 150₂ 150₃ et 150₄ La première ouverture 158 traverse en outre la face rectangulaire 132 du premier conduit 130 et débouche sur l'intérieur du boitier 160. Ainsi, lorsque le premier et le troisième composant électronique 170,172 sont introduits au moins partiellement dans l'ouverture 158, le premier et le troisième composant électronique 170,172 sont en contact direct ou seulement par l'intermédiaire d'une pâte thermique avec le premier et deuxième caloduc 110, 210. De cette façon, le contact thermique entre les premier et troisième composant 170,172 et les premier et deuxième caloduc 110,210 est amélioré puisque ce contact thermique ne se fait plus par l'intermédiaire de la face rectangulaire 152.

Le premier caloduc 110 ou le deuxième caloduc 210 peuvent présenter une section circulaire ou une section semi-circulaire. De façon optionnelle, lorsque le premier caloduc 110 et/ou le deuxième caloduc 210 présentent une section semi circulaire, les premier et/ou deuxième caloduc 110,210 peuvent comporter une surface plane, qui lorsque les premier et/ou deuxième caloduc 110,210 sont introduit dans le premier conduit 130 est placée en regard de l'intérieur du boitier 160 ce qui permet d'avoir une surface de contact thermique avec le premier et/ou le troisième composants électroniques 170,172 plus importante que lorsque le premier et/ou le deuxième caloduc 110 présentent une section circulaire.

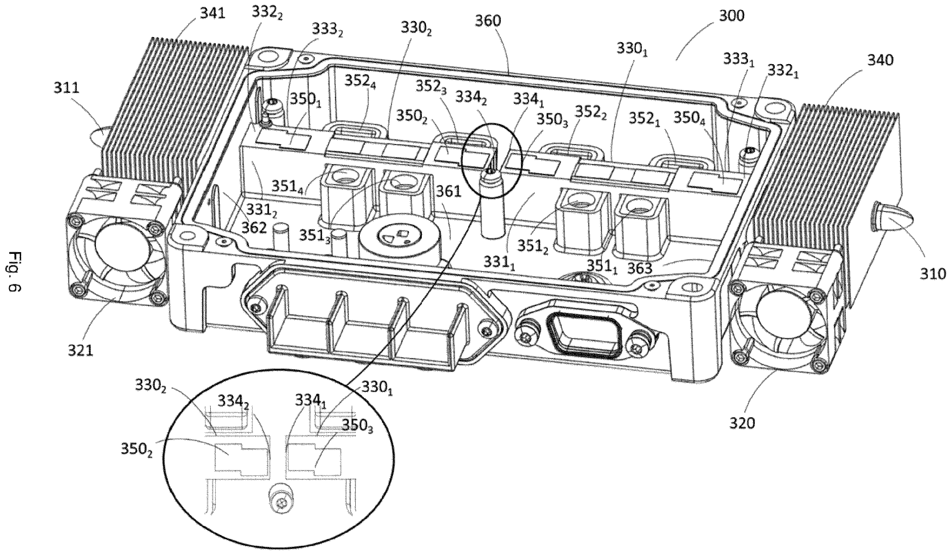

En référence à la figure 6, un convertisseur de tension 300 selon un troisième mode de réalisation de l'invention va être décrit. Le convertisseur de tension 300 est par exemple utilisé dans un véhicule automobile.

Le convertisseur de tension 300 comprend un système électronique. Ce système électronique comprend un boitier 360, au moins un premier, un deuxième, un troisième et un quatrième composant électronique 370, 371, 372, 373 (non représentés sur les figures) à refroidir et placés à l'intérieur du boitier 360, un premier et un deuxième radiateur 340, 341, un premier et un deuxième ventilateur 320, 321 et un premier et un deuxième caloduc 310, 311.

Le premier et le troisième composants électroniques 370, 372 sont par exemple des interrupteurs électroniques tel qu'un MOSFET ou un IGBT faisant par exemple partis de bras de commutation du convertisseur de tension 300.

Le deuxième et le quatrième composants électroniques 371, 373 sont par exemple des inductances. On notera que dans l'exemple décrit ici, le deuxième et le quatrième composants électroniques 371, 373 dissipent en fonctionnement plus de chaleur que le deuxième et le quatrième composants électroniques 371, 373.

Le premier caloduc 310 et le deuxième caloduc 311 se présentent sous la forme d'un tube fermé de section circulaire, par exemple en cuivre, dans lequel un fluide caloporteur circule. De façon connu, le premier caloduc 310 et le deuxième caloduc 311 comprennent chacun une première extrémité où le fluide se vaporise en absorbant de l'énergie thermique et une deuxième extrémité où le fluide se condense pour retourner à l'état liquide, la circulation du fluide au sein du premier caloduc 310 et du deuxième caloduc 311 se faisant par exemple par capillarité.

Dans l'exemple décrit, le boitier 360 est un parallélépipède rectangle comprenant un fond 361 entouré d'une première 363, d'une deuxième 362, d'une troisième et d'une quatrième paroi. La longueur de la première et deuxième paroi définit la largeur du boitier, et la longueur de la troisième et quatrième paroi définit la longueur du boitier. Le fond 361 et les quatre parois du boitier 360 définissent en outre un logement intérieur du boitier.

Dans l'exemple décrit, le boitier 360 est un boitier métallique, par exemple en aluminium.

Dans l'exemple décrit ici, le fond 361 comprend en outre un premier conduit 330₁ et un deuxième conduit 330₂.

Le premier conduit 330₁, respectivement le deuxième conduit 330₂, forme une première excroissance, respectivement une deuxième excroissance par rapport au reste de la surface sensiblement plane du fond 361. La première excroissance à une forme parallélépipédique qui s'étend à partir de la deuxième paroi 362 jusqu'à sensiblement le milieu du boitier 360 et la deuxième excroissance à une forme parallélépipédique qui s'étend à partir de la première paroi 361 jusqu'à sensiblement le milieu du boitier 360. L'intérieur du premier conduit 330₁ est usiné à partir de la deuxième paroi 362. Un tel usinage réalise une ouverture dans la deuxième paroi 362 au travers de laquelle l'intérieur du premier conduit 330₁ débouche sur l'extérieur du boitier 360. L'intérieur du deuxième conduit 330₂ est usiné à partir de la première paroi 363. Un tel usinage réalise une ouverture dans la première paroi 363 au travers de laquelle l'intérieur du deuxième conduit 330₂ débouche sur l'extérieur du boitier 360.

En variante, le premier conduit 330₁ et le deuxième conduit 330₂ ont une forme parallélépipédique et sont disposés sur la face intérieure du fond 361 du boitier 360. En d'autres termes, le premier conduit 330₁ est le second conduit 330₂ ne sont pas réalisés en continuité de matière avec le boitier 360 mais ils sont réalisés indépendamment du fond 361 et fixés sur ce fond 361. Le premier conduit 330₁ s'étend à partir de la deuxième paroi 362 jusqu'à sensiblement le milieu du boitier 360 et le deuxième conduit 330₂ s'étend à partir de la première paroi 363 jusqu'à sensiblement le milieu du boitier 360. Dans cette variante de réalisation, la deuxième paroi 362 comporte une ouverture qui se trouve placée, après assemblage du premier conduit 330₁ sur le boitier 360, en vis-à-vis de l'intérieure du premier conduit 330₁ de sorte que l'intérieur du premier conduit 330₁ débouche par cette ouverture sur l'extérieur du boitier 360. De même, la première paroi 363 comporte une ouverture qui se trouve placée, après assemblage du deuxième conduit 330₂ sur le boitier 360, en vis-à-vis de l'intérieure du deuxième conduit 330₂ de sorte que l'intérieur du deuxième conduit 330₂ débouche par cette ouverture sur l'extérieur du boitier 360.

Dans l'exemple décrit ici, et de façon optionnelle, l'axe de symétrie du premier conduit 330₁ et du deuxième conduit 330₂ sont sensiblement alignés et les deux conduits sont parallèles à la troisième et à la quatrième paroi du boitier 361.

Dans l'exemple décrit ici, l'intérieur du premier conduit 330₁ et du deuxième conduit 330₂ à une forme tubulaire creuse dont la section est de forme sensiblement circulaire. En variante, la section de la forme tubulaire creuse de ces deux conduits 330₁, 330₂ peut être sensiblement rectangulaire.

En outre, la section de la forme tubulaire creuse du premier conduit 330₁, respectivement du deuxième conduit 330₂ est suffisamment importante pour permettre l'introduction en son sein de la première extrémité du premier caloduc 310, respectivement du deuxième caloduc 311.

En outre, dans l'exemple décrit ici, le premier conduit 330₁ présente quatre faces rectangulaires extérieures 331₁, 332₁, 333₁, 334₁ accessibles depuis le logement intérieur du boitier 360. Les deux faces rectangulaires 331₁, 333₁ sont parallèles à la troisième et à la quatrième paroi du boitier 360 tandis que la face rectangulaire 332₁ est parallèle au fond 361 du boitier 360. En outre, la face rectangulaire 334₁ est parallèle à la première 363 et à la deuxième 362 face du boitier 360 En variante, le premier conduit 330₁ peut présenter seulement trois faces extérieures, voire seulement deux faces extérieures, accessibles depuis le logement intérieur du boitier 360.

Les trois faces rectangulaires 331₁, 332₁, 333₁ présentent des zones de réceptions 350₃, 350₄, 351₁, 351₂, 352₁, 352₂, en contact avec des composants électroniques du convertisseur de tension 300.

Les zones de réception 351₁, 351₂, 352₁, 352₂ sont constituées de cavités de réception de composants électronique, chacune desdites cavités étant réalisées dans une excroissance faisant saillie à partir des faces rectangulaires 331₁, 333₁ du premier conduit 330₁.

Dans l'exemple décrit ici, les ouvertures des cavités des zones de réception 351₁, 351₂, 352₁, 352₂ sont parallèles au fond 361 du boitier 360.

Les zones de réception 350₃, 350₄ font parties de la surface extérieure de la face rectangulaire 332₁.

En outre, dans l'exemple décrit ici, le deuxième conduit 330₂ présente quatre faces rectangulaires extérieures 331₂, 332₂, 333₂, 334₂ accessibles depuis le logement intérieur du boitier 360. Les deux faces rectangulaires 331₂, 333₂ sont parallèles à la troisième et à la quatrième paroi du boitier 360 tandis que la face rectangulaire 332₂ est parallèle au fond 361 du boitier 360. En outre, la face rectangulaire 334₂ est parallèle à la première et à la deuxième face du boitier 360 En variante, le premier conduit 330₁ peut présenter seulement trois faces extérieures, voire seulement deux faces extérieures, accessibles depuis le logement intérieur du boitier 360.

Les trois faces rectangulaires 331₂, 332₂, 333₂ présentent des zones de réceptions 350₁, 350₂, 351₃, 351₄, 352₃, 352₄, en contact avec des composants électroniques du convertisseur de tension 300.

Les zones de réception 351₃, 351₄, 352₃, 352₄ sont constituées de cavités de réception de composants électronique, chacune desdites cavités étant réalisées dans une excroissance faisant saillie à partir des faces rectangulaires 331₂, 333₂ du deuxième conduit 330₂.

Dans l'exemple décrit ici, les ouvertures des cavités des zones de réception 351₃, 351₄, 352₃, 352₄ sont parallèles au fond 361 du boitier 360.

Les zones de réception 350₁, 350₂ font partie de la surface extérieure de la face rectangulaire 332₂.

Dans l'exemple décrit ici, le premier composant électronique 370 est placé en contact de la zone de réception 350₁ par l'intermédiaire d'une pâte thermique et le deuxième composant électronique 371 est placé en contact de la zone de réception 351₃ par l'intermédiaire d'une pâte thermique. En outre, le troisième composant électronique 372 est placé en contact de la zone de réception 350₄ par l'intermédiaire d'une pâte thermique et le quatrième composant électronique 373 est inséré dans la cavité de la zone de réception 351₄, le contact entre le quatrième composant électronique 373 et une partie de ladite cavité s'effectuant également au moyen d'une pâte thermique.

Le premier radiateur 340 est composé d'un empilage d'ailettes métalliques de forme rectangulaire. Les ailettes métalliques sont séparées par un espace pour permettre le passage d'un flux d'air entre elles.

Le premier radiateur 340 et le premier ventilateur 320 sont fixés à l'extérieur du boitier 360, i.e. à l'extérieur du logement intérieur du boitier 360, sur la première paroi 363. Le premier ventilateur 320 est en outre fixé sur la première paroi 363 de façon à refroidir le premier radiateur 340. En d'autres termes, Le premier ventilateur 320 et le premier radiateur 340 sont fixés sur la première paroi 363 de sorte que les ailettes métalliques du premier radiateur 340 soient parallèles à la première paroi 363 et que le premier ventilateur, lorsqu'il est en fonctionnement, génère un flux d'air passant entre lesdites ailettes métalliques permettant ainsi leur refroidissement.

Dans l'exemple décrit ici, le premier ventilateur 320 est un ventilateur axial. En variante, le premier ventilateur 320 peut être un ventilateur radial ou tangentiel.

En outre, chacune des ailettes métalliques du premier radiateur 340 comprend une ouverture, ces ouvertures étant suffisamment larges et positionnées en regard les unes des autres de façon à permettre l'introduction, depuis l'extérieur du boitier 360, d'une extrémité du premier caloduc 310 dans la section de forme tubulaire creuse du premier conduit 330₁.

Ainsi, le premier caloduc 310 traverse, avant son introduction dans la section de forme tubulaire creuse du premier conduit 330₁, les ailettes métalliques du premier radiateur 340 et la première paroi 363 du boitier 360.

Après son introduction, le premier caloduc 310 est disposé dans le premier conduit 330₁ de sorte que sa première extrémité est en contact thermique avec les zones de réception 350₃, 350₄, 351₁, 351₂, 352₁, 352₂ et de sorte que sa deuxième extrémité est en contact thermique avec les ailettes métalliques du premier radiateur 340. Ainsi, dans ce troisième mode de réalisation de l'invention, le premier caloduc 310 pénètre jusqu'au fond du premier conduit 330₁.

Le premier caloduc 310 peut optionnellement être fixé au premier radiateur 340 par sertissage.

Le deuxième radiateur 341 est composé d'un empilage d'ailettes métalliques de forme rectangulaire. Les ailettes métalliques sont séparées par un espace pour permettre le passage d'un flux d'air entre elles.

Le deuxième radiateur 341 et le deuxième ventilateur 321 sont fixés à l'extérieur du boitier 360, i.e. à l'extérieur du logement intérieur du boitier 360, sur la deuxième paroi 362. Le deuxième ventilateur 321 est en outre fixé sur la deuxième paroi 362 de façon à refroidir le deuxième radiateur 341. En d'autres termes, Le deuxième ventilateur 321 et le deuxième radiateur 341 sont fixés sur la deuxième paroi 362 de sorte que les ailettes métalliques du deuxième radiateur 341 soient parallèles à la deuxième paroi 362 et que le deuxième ventilateur, lorsqu'il est en fonctionnement, génère un flux d'air passant entre lesdites ailettes métalliques permettant ainsi leur refroidissement.

Dans l'exemple décrit ici, le deuxième ventilateur 321 est un ventilateur axial. En variante, le deuxième ventilateur 321 peut être un ventilateur radial ou tangentiel.

En outre, chacune des ailettes métalliques du deuxième radiateur 341 comprend une ouverture, ces ouvertures étant suffisamment larges et positionnées en regard les unes des autres de façon à permettre l'introduction, depuis l'extérieur du boitier 360, d'une extrémité du deuxième caloduc 311 dans la section de forme tubulaire creuse du deuxième conduit 330₂.

Ainsi, le deuxième caloduc 311 traverse, avant son introduction dans la section de forme tubulaire creuse du deuxième conduit 330₂, les ailettes métalliques du deuxième radiateur 341 et la deuxième paroi 362 du boitier 360.

Après son introduction, le deuxième caloduc 311 est disposé au moins partiellement dans le deuxième conduit 330₂ de sorte que sa première extrémité est en contact thermique avec les zones de réception 350₁, 350₂, 351₃, 351₄, 352s, 352₄ et de sorte que sa deuxième extrémité est en contact thermique avec les ailettes métalliques du deuxième radiateur 341.

Le deuxième caloduc 311 peut optionnellement être fixé au deuxième radiateur 341 par sertissage.

Lorsque le convertisseur de tension 300 est en marche, les premier et deuxième composants électroniques 370, 371 s'échauffent et leur température augmente. L'énergie thermique dissipée par les premier et deuxième composants électroniques 370, 371 en fonctionnement est alors drainée vers les zones de réception 350₃, 351₂ du premier conduit 330₁ par l'intermédiaire de la pâte thermique, puis de ces zones de réception 350₃, 351₂ du premier conduit 330₁ vers la première extrémité du premier caloduc 310. Au niveau de cette première extrémité, le fluide caloporteur du premier caloduc 310 se vaporise en absorbant l'énergie thermique émise par les premier et deuxième composants électroniques 370, 371. La vapeur circule alors dans le premier caloduc 310 jusqu'à sa deuxième extrémité située au niveau des ailettes métalliques du premier radiateur 340 où elle se condense pour retourner à l'état liquide. Durant la phase de condensation l'énergie thermique est transmise du premier caloduc 310 au premier radiateur 340 refroidi par le premier ventilateur 320.

De même, lorsque le convertisseur de tension 300 est en marche, les troisième et quatrième composants électroniques 372, 373 s'échauffent et leur température augmente. L'énergie thermique dissipée par les troisième et quatrième composants électroniques 372, 373 en fonctionnement est alors drainée vers les zones de réception 350₂, 351₃ du deuxième conduit 330₂ par l'intermédiaire de la pâte thermique, puis de ces zones de réception 350₂, 351₃ du deuxième conduit 330₂ vers la première extrémité du deuxième caloduc 311. Au niveau de cette première extrémité, le fluide caloporteur du deuxième caloduc 311 se vaporise en absorbant l'énergie thermique émise par les troisième et quatrième composants électroniques 372, 373. La vapeur circule alors dans le deuxième caloduc 311 jusqu'à sa deuxième extrémité située au niveau des ailettes métalliques du deuxième radiateur 341 où elle se condense pour retourner à l'état liquide. Durant la phase de condensation l'énergie thermique est transmise du deuxième caloduc 311 au deuxième radiateur 341 refroidi par le deuxième ventilateur 321.

En outre et de façon optionnelle, le boitier 360 peut être hermétiquement clos. Et dans ce cas le boitier 360 comprend un couvercle et des moyens d'étanchéité. Ces moyens d'étanchéité comprennent par exemple un joint d'étanchéité entre le boitier 360 et son couvercle, et dans le cas où le premier conduit 330₁ et le deuxième conduit 330₂ sont disposés sur la face intérieure du fond du boitier 361 du boitier 360 des joints d'étanchéité additionnels sont disposés entre les première et deuxième parois 363,362 et le boitier 360. L'intérieur du boitier 360 et l'intérieur des premier 330₁ et du deuxième conduits 330₂ sont hermétiquement séparés, en d'autres termes il n'existe pas d'ouverture dans les premier et deuxième conduits 330₁,330₂ débouchant sur l'intérieur du boitier 360.

Ainsi, le premier caloduc 310 le deuxième caloduc 311, le premier conduit 330₁, le deuxième conduit 330₂, le premier radiateur 340 le deuxième radiateur 341, le premier ventilateur 320 et le deuxième ventilateur 321 constitue un dispositif de refroidissement des premier, deuxième, troisième et quatrième composants électroniques 570,571,572,573.

Dans une première variante du troisième mode de réalisation de l'invention non représentée sur les figures, le premier conduit 330₁ présente une première ouverture 358 sur la face rectangulaire 332₁. La première ouverture 358 est réalisée en lieu et place de la zone de réception 350₃. La première ouverture 358 traverse la face rectangulaire 332₁ du premier conduit 330₁ et débouche sur l'intérieur du boitier 360. Ainsi, lorsque un composant électronique est introduit au moins partiellement dans la première ouverture 358, ce composant électronique est en contact direct ou seulement par l'intermédiaire d'une pâte thermique avec le premier caloduc 310. De cette façon, le contact thermique entre le composant électronique 372 et le premier caloduc 310 est amélioré puisque ce contact thermique ne se fait plus par l'intermédiaire de la face rectangulaire 332₁.

En variante, la première ouverture 358 peut également être réalisée dans les face rectangulaires 331₁, 333₁ à côté ou en lieu et place des zones de réception 351₁ ,351₂.,352₂, 352₁.

Le premier caloduc 310 peut présenter une section circulaire ou une section semi-circulaire. De façon optionnelle, lorsque le premier caloduc 310 présente une section semi circulaire, le premier caloduc 310 peut comporter une surface plane, qui lorsque le premier caloduc 310 est introduit dans le premier conduit 330₁ est placée en regard de l'intérieur du boitier 360 ce qui permet d'avoir une surface de contact thermique avec le composant électronique introduit dans la première ouverture 358 plus importante que lorsque le premier caloduc 310 présente une section circulaire.

Le deuxième conduit 330₂ présente une deuxième ouverture 359 sur la face rectangulaire 332₂. La deuxième ouverture 359 est réalisée en lieu et place de la zone de réception 350₂. La deuxième ouverture 359 traverse la face rectangulaire 332₂ du deuxième conduit 330₂ et débouche sur l'intérieur du boitier 360. Ainsi, lorsque uncomposant électronique est introduit au moins partiellement dans la deuxième ouverture 359, ce composant électronique est en contact direct ou par l'intermédiaire d'une pâte thermique avec le deuxième caloduc 311. De cette façon, le contact thermique entre ce composant électronique et le deuxième caloduc 311 est amélioré puisque ce contact thermique ne se fait plus par l'intermédiaire de la face rectangulaire 332₂.

En variante, la deuxième ouverture 359 peut également être réalisée dans les face rectangulaires 331₂, 333₂ à côté ou en lieu et place des zones de réception 351₃, 351₄, 352₄, 352₃.

Le deuxième caloduc 311 peut présenter une section circulaire ou une section semi-circulaire. De façon optionnelle, lorsque le deuxième caloduc 311 présente une section semi circulaire, le deuxième caloduc 311 peut comporter une surface plane, qui lorsque le deuxième caloduc 311 est introduit dans le deuxième conduit 330₂ est placée en regard de l'intérieur du boitier 360 ce qui permet d'avoir une surface de contact thermique avec le composant électronique introduit dans la deuxième ouverture 359 plus importante que lorsque le deuxième caloduc 311 présente une section circulaire.

Dans une deuxième variante du troisième mode de réalisation de l'invention non représentée sur les figures, le premier conduit 330₁ présente une première ouverture 358 sur la face rectangulaire 332₁ qui s'étend de la première paroi 363 à la face rectangulaire 334₁. Ainsi, la première ouverture 358 est réalisée en lieu et place des zones de réception 350₃ et 350₄ La première ouverture 358 traverse en outre la face rectangulaire 332₁ du premier conduit 330₁ et débouche sur l'intérieur du boitier 360. Ainsi, lorsque le troisième composant électronique 372 est introduit au moins partiellement dans l'ouverture 358, le troisième composant électronique 372 est en contact direct ou seulement par l'intermédiaire d'une pâte thermique avec le premier caloduc 310. De cette façon, le contact thermique entre le troisième composant 372 et le premier caloduc 310 est amélioré puisque ce contact thermique ne se fait plus par l'intermédiaire de la face rectangulaire 332₁.

Le premier caloduc 310 peut présenter une section circulaire ou une section semi-circulaire. De façon optionnelle, lorsque le premier caloduc 310 présente une section semi circulaire, le premier caloduc 310 peut comporter une surface plane, qui lorsque le premier caloduc 310 est introduit dans le premier conduit 330₁ est placée en regard de l'intérieur du boitier 360 ce qui permet d'avoir une surface de contact thermique avec le troisième composant électronique 372 plus importante que lorsque le premier caloduc 310 présente une section circulaire.

Le deuxième conduit 330₂ présente une deuxième ouverture 359 sur la face rectangulaire 332₂ qui s'étend de la deuxième paroi 362 à la face rectangulaire 334₂. Ainsi, la deuxième ouverture 359 est réalisée en lieu et place des zones de réception 350₁ et 350₂ La deuxième ouverture 359 traverse en outre la face rectangulaire 332₂ du deuxième conduit 330₂ et débouche sur l'intérieur du boitier 360. Ainsi, lorsque le premier composant électronique 370 est introduit au moins partiellement dans la deuxième ouverture 359, le premier composant électronique 370 est en contact direct ou par l'intermédiaire d'une pâte thermique avec le deuxième caloduc 311. De cette façon, le contact thermique entre le premier composant 370 et le deuxième caloduc 311 est amélioré puisque ce contact thermique ne se fait plus par l'intermédiaire de la face rectangulaire 332₂.

Le deuxième caloduc 311 peut présenter une section circulaire ou une section semi-circulaire. De façon optionnelle, lorsque le deuxième caloduc 311 présente une section semi circulaire, le deuxième caloduc 311 peut comporter une surface plane, qui lorsque le deuxième caloduc 311 est introduit dans le deuxième conduit 330₂ est placée en regard de l'intérieur du boitier 360 ce qui permet d'avoir une surface de contact thermique avec le premier composant électronique 370 plus importante que lorsque le deuxième caloduc 311 présente une section circulaire.

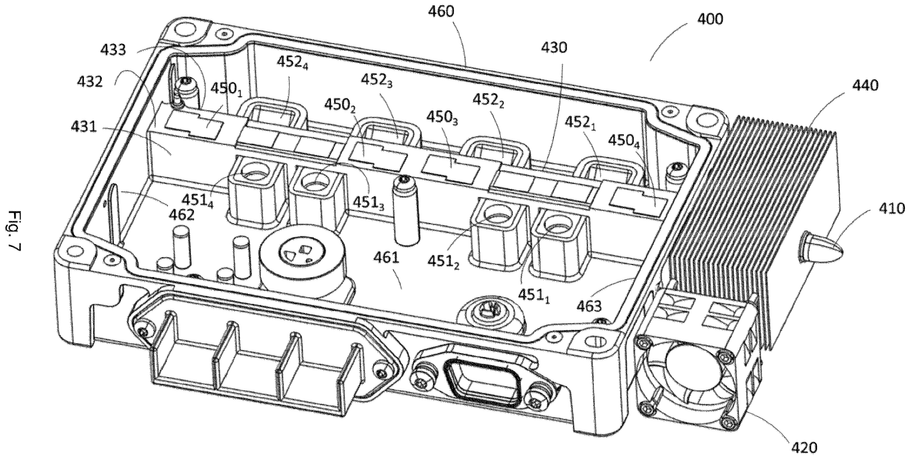

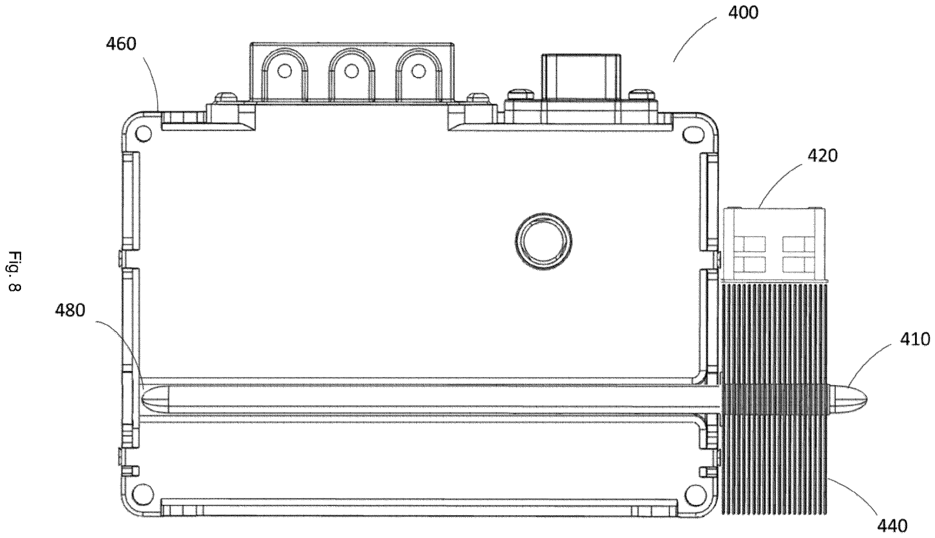

En référence aux figures 7 et 8, un convertisseur de tension 400 selon un quatrième mode de réalisation de l'invention va être décrit. Le convertisseur de tension 400 est par exemple utilisé dans un véhicule automobile.

Le convertisseur de tension 400 comprend un système électronique. Ce système électronique comprend un boitier 460, au moins un premier et un deuxième composant électronique 470, 471 (non représentés sur les figures) à refroidir et placés à l'intérieur du boitier 460, un premier radiateur 440, un premier ventilateur 420 et un premier caloduc 410.

Le premier composant électronique 470 est par exemple un interrupteur électronique tel qu'un MOSFET ou un IGBT faisant partie d'un bras de commutation du convertisseur de tension 400.

Le deuxième composant électronique 471 est par exemple une inductance. On notera que dans l'exemple décrit ici, le premier composant électronique 470 dissipe en fonctionnement plus de chaleur que le deuxième composant électronique 471.

Le premier caloduc 410 se présente sous la forme d'un tube fermé de section circulaire, par exemple en cuivre, dans lequel un fluide caloporteur circule. De façon connu, le premier caloduc 410 comprend une première extrémité où le fluide se vaporise en absorbant de l'énergie thermique et une deuxième extrémité où le fluide se condense pour retourner à l'état liquide, la circulation du fluide au sein du premier caloduc 410 se faisant par exemple par capillarité.

Dans l'exemple décrit, le boitier 460 est un parallélépipède rectangle comprenant un fond 461 entouré d'une première 463, d'une deuxième 462, d'une troisième et d'une quatrième paroi. La longueur de la première et deuxième paroi définit la largeur du boitier, et la longueur de la troisième et quatrième paroi définit la longueur du boitier. Le fond 461 et les quatre parois du boitier 461 définissent en outre un logement intérieur du boitier.

Dans l'exemple décrit, le boitier 460 est un boitier métallique, par exemple en aluminium.

Dans l'exemple décrit ici, le fond 461 comprend, sur sa face intérieure au boitier 460 et par rapport au reste de la surface sensiblement plane du fond 461, une excroissance de forme parallélépipédique qui s'étend entre la première 463 et la deuxième paroi 462 du boitier 460. Le boitier 460 comprend en outre un premier conduit 430. Le premier conduit 430 comprend une cavité 480 formée dans la face extérieure du fond 461 de sorte que ladite cavité 480 soit au moins en partie comprise dans ladite excroissance. Ainsi, l'intérieur du premier conduit 430 est délimité par l'intérieur de la cavité 480. Cette cavité est par exemple usinée à partir de l'extérieur du fond 461.

Dans l'exemple décrit ici, l'intérieur du premier conduit 430 est obstrué par la deuxième paroi 462 mais débouche sur l'extérieur du boitier 460 au niveau de la première paroi 463. En d'autres termes, la première paroi 463 comprend une ouverture qui se trouve placée en vis-à-vis de l'intérieur du premier conduit 430.

En variante, l'intérieur du premier conduit 430 débouche sur l'extérieur du boitier 460 au niveau de la première paroi 463 et de la deuxième paroi 462. En d'autres termes, la deuxième paroi 462 comprend également dans cette variante une ouverture qui se trouve placée en vis-à-vis de l'intérieur du premier conduit 430.

Dans l'exemple décrit ici, l'intérieur du premier conduit 430 à une forme tubulaire creuse dont la forme de la section correspond à une demi-ellipse. En variante, la section de la forme tubulaire creuse peut être sensiblement rectangulaire.

En outre, la section de la forme tubulaire creuse est suffisamment importante pour permettre l'introduction en son sein de la première extrémité du premier caloduc 410.

En outre, dans l'exemple décrit ici, le premier conduit 430 présente trois faces rectangulaires extérieures 431, 432, 433 accessibles depuis le logement intérieur du boitier 460. Les deux faces rectangulaires 431, 433 sont parallèles à la troisième et à la quatrième paroi du boitier 460 tandis que la face rectangulaire 432 est parallèle au fond 461 du boitier 460. En variante, le premier conduit 430 peut présenter seulement deux faces extérieures, voire une seule face extérieure, accessibles depuis le logement intérieur du boitier 460.

Les trois faces rectangulaires 431, 432, 433 présentent des zones de réceptions 450₁, 450₂, 450₃, 450₄, 451₁, 451₂, 451₃, 451₄, 452₁, 452₂, 452₃, 452₄ en contact avec des composants électroniques du convertisseur de tension 400.

Les zones de réception 451₁, 451₂, 451₃, 451₄, 452₁, 452₂, 452₃, 452₄ sont constitué de cavités de réception de composants électroniques, chacune desdites cavités étant réalisées dans une excroissance faisant saillie à partir des faces rectangulaires 431, 433 du premier conduit 430.

Dans l'exemple décrit ici, les ouvertures des cavités des zones de réception 451₁, 451₂, 451₃, 451₄, 452₁, 452₂, 452₃, 452₄ sont parallèles au fond 461 du boitier 460.

Les zones de réception 450₁, 450₂, 450₃, 450₄ font parties de la surface extérieure de la face rectangulaire 432.

Dans l'exemple décrit ici, le premier composant électronique 470 est placé en contact de l'une des zones de réception 450₁, 450₂, 450₃, 450₄ par l'intermédiaire d'une pâte thermique et le deuxième composant électronique 471 est inséré dans une cavité d'une zone de réception 451₁, 451₂, 451₃, 451₄, le contact entre le deuxième composant électronique 471 et une partie de ladite cavité s'effectuant également au moyen d'une pâte thermique.

De façon préférentielle, le premier composant électronique 470 qui dissipe plus de chaleur que le deuxième composant électronique 471 est placé dans une zone de réception 450₁, 450₂, 450₃, 450₄ qui est plus éloignée de la deuxième paroi 463 que ne l'est la zone de réception 451₁, 451₂, 451₃, 451₄ où est placé le deuxième composant électronique 471.

Le premier radiateur 440 est composé d'un empilage d'ailettes métalliques de forme rectangulaire. Les ailettes métalliques sont séparées par un espace pour permettre le passage d'un flux d'air entre elles.

Le premier radiateur 440 et le premier ventilateur 420 sont fixés à l'extérieur du boitier 460, i.e. à l'extérieur du logement intérieur du boitier 460, sur la première paroi 463. Le premier ventilateur 420 est en outre fixé sur la première paroi 463 de façon à refroidir le premier radiateur 440. En d'autres termes, Le premier ventilateur 420 et le premier radiateur 440 sont fixés sur la première paroi 463 de sorte que les ailettes métalliques du premier radiateur 440 soient parallèles à la première paroi 463 et que le premier ventilateur, lorsqu'il est en fonctionnement, génère un flux d'air passant entre lesdites ailettes métalliques permettant ainsi leur refroidissement.

Dans l'exemple décrit ici, le premier ventilateur 420 est un ventilateur axial. En variante, le premier ventilateur 420 peut être un ventilateur radial ou tangentiel.

En outre, chacune des ailettes métalliques du premier radiateur 440 comprend une ouverture, ces ouvertures étant suffisamment larges et positionnées en regard les unes des autres de façon à permettre l'introduction, depuis l'extérieur du boitier 460, d'une extrémité du premier caloduc 410 dans la section de forme tubulaire creuse du premier conduit 430.

Ainsi, le premier caloduc 410 traverse, avant son introduction dans la section de forme tubulaire creuse du premier conduit 430, les ailettes métalliques du premier radiateur 440 et la première paroi 463 du boitier 460.

Après son introduction, le premier caloduc 410 est disposé dans le premier conduit 430 de sorte que sa première extrémité est en contact thermique avec les zones de réception 450₁, 450₂, 450₃, 450₄, 451₁, 451₂, 451₃, 451₄, 452₁, 452₂, 452₃, 452₄ et de sorte que sa deuxième extrémité est en contact thermique avec les ailettes métalliques du premier radiateur 440. Ainsi, dans ce quatrième mode de réalisation de l'invention, le premier caloduc 410 pénètre jusqu'au fond du premier conduit 430.

Le premier caloduc 410 peut optionnellement être fixé au premier radiateur 440 par sertissage.

Lorsque le convertisseur de tension 400 est en marche, les premier et deuxième composants électroniques 470, 471 s'échauffent et leur température augmente. L'énergie thermique dissipée par les composants électroniques 470, 471 en fonctionnement est alors drainée vers les zones de réception du premier conduit 430 par l'intermédiaire de la pâte thermique, puis du premier conduit 430 vers la première extrémité du premier caloduc 410. Au niveau de cette première extrémité, le fluide caloporteur du premier caloduc 410 se vaporise en absorbant l'énergie thermique émise par les premier et deuxième composants électroniques 470, 471. La vapeur circule alors dans le premier caloduc 410 jusqu'à sa deuxième extrémité située au niveau des ailettes métalliques du premier radiateur 440 où elle se condense pour retourner à l'état liquide. Durant la phase de condensation l'énergie thermique est transmise du premier caloduc au premier radiateur 440 refroidi par le premier ventilateur 420.

En outre et de façon optionnelle, le boitier 460 peut être hermétiquement clos. Et dans ce cas le boitier 460 comprend un couvercle et des moyens d'étanchéité. Ces moyens d'étanchéité comprennent par exemple un joint d'étanchéité entre le boitier 460 et son couvercle. L'intérieur du boitier 460 et l'intérieur du premier conduit 430 sont hermétiquement séparés, en d'autres termes il n'existe pas d'ouverture dans le premier conduit 430 débouchant sur l'intérieur du boitier 460

Ainsi, le premier caloduc 410, le premier conduit 430, le premier radiateur 440 et le premier ventilateur 420 constitue un dispositif de refroidissement des premier et deuxième composants électroniques 470, 471.

Dans une première variante du quatrième mode de réalisation de l'invention non représentée sur les figures, le premier conduit 430 présente une première ouverture 458 sur la face rectangulaire 432. La première ouverture 458 est réalisée en lieu et place des zones de réception 450₂ et 450₃. La première ouverture 458 traverse la face rectangulaire 432 du premier conduit 430 et débouche sur l'intérieur du boitier 460. Ainsi, lorsque le premier composant électronique 470 est introduit au moins partiellement dans la première ouverture 458, le premier composant électronique 470 est en contact direct ou seulement par l'intermédiaire d'une pâte thermique avec le premier caloduc 410. De cette façon, le contact thermique entre le premier composant électronique 470 et le premier caloduc 410 est amélioré puisque ce contact thermique ne se fait plus par l'intermédiaire de la face rectangulaire 432.

En variante, la première ouverture 458 peut également être réalisée dans les face rectangulaires 431, 433 à côté ou en lieu et place des zones de réception 451₁ à 451₄ et 452₁ à 452₄.

Le premier caloduc 410 peut présenter une section circulaire ou une section semi-circulaire. De façon optionnelle, lorsque le premier caloduc 410 présente une section semi circulaire, le premier caloduc 410 peut comporter une surface plane, qui lorsque le premier caloduc 410 est introduit dans le premier conduit 430 est placée en regard de l'intérieur du boitier 460 ce qui permet d'avoir une surface de contact thermique avec le premier composant électronique 470 plus importante que lorsque le premier caloduc 410 présente une section circulaire.

Dans une deuxième variante du premier mode de réalisation de l'invention non représenté, le premier conduit 430 présente une première ouverture 458 sur la face rectangulaire 432 qui s'étend de la première paroi 463 à la deuxième paroi 462. Ainsi, la première ouverture 458 est réalisée en lieu et place des zones de réception 450₁, 450₂, 450₃ et 450₄. La première ouverture 458 traverse en outre la face rectangulaire 432 du premier conduit 430 et débouche sur l'intérieur du boitier 460. Ainsi, lorsque le premier composant électronique 470 est introduit au moins partiellement dans l'ouverture 458, le premier composant électronique 470 est en contact direct ou seulement par l'intermédiaire d'une pâte thermique avec le premier caloduc 410. De cette façon, le contact thermique entre le premier composant 470 et le premier caloduc 410 est amélioré puisque ce contact thermique ne se fait plus par l'intermédiaire de la face rectangulaire 432.

Le premier caloduc 410 peut présenter une section circulaire ou une section semi-circulaire. De façon optionnelle, lorsque le premier caloduc 410 présente une section semi circulaire, le premier caloduc 410 peut comporter une surface plane, qui lorsque le premier caloduc 410 est introduit dans le premier conduit 430 est placée en regard de l'intérieur du boitier 460 ce qui permet d'avoir une surface de contact thermique avec le premier composant électronique 470 plus importante que lorsque le premier caloduc 410 présente une section circulaire.

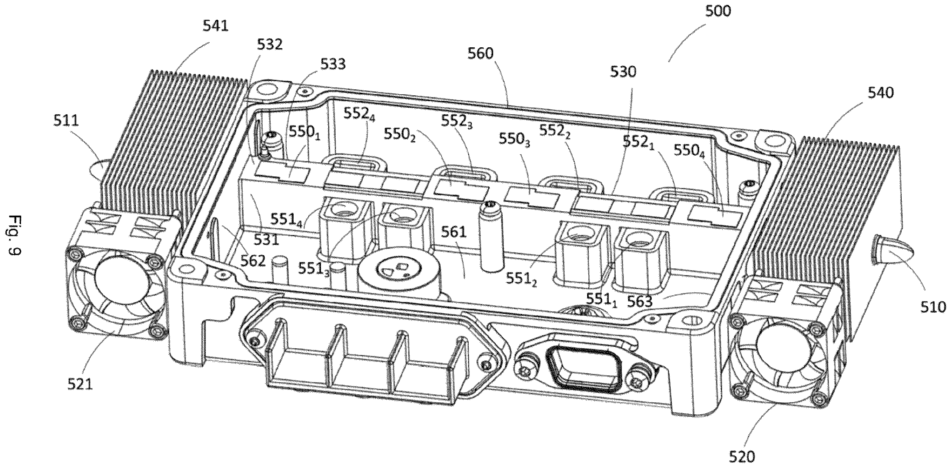

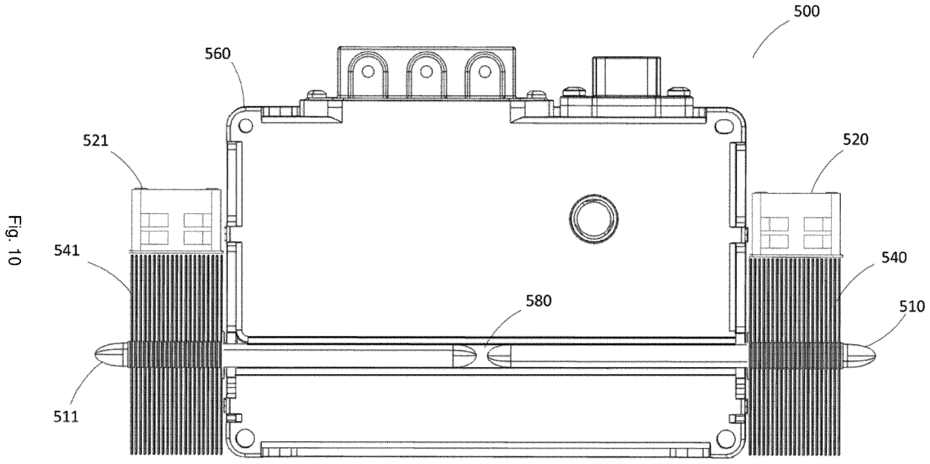

En référence aux figures 9 et 10, un convertisseur de tension 500 selon un cinquième mode de réalisation de l'invention va être maintenant décrit.

Le convertisseur de tension 500 comprend un système électronique. Ce système électronique comprend un boitier 560, au moins un premier, un deuxième, un troisième et un quatrième composant électronique 570, 571, 572, 573 (non représentés sur les figures) à refroidir et placés à l'intérieur du boitier 560, un premier et un deuxième radiateur 540, 541, un premier et un deuxième ventilateur 520, 521 et un premier et un deuxième caloduc 510, 511.

Le premier et le troisième composants électroniques 570, 572 sont par exemple des interrupteurs électroniques tel qu'un MOSFET ou un IGBT faisant partie d'un bras de commutation du convertisseur de tension 500.

Le deuxième et le quatrièmes composants électroniques 571, 573 sont par exemple des inductances. On notera que dans l'exemple décrit ici, les deuxième et quatrième composants électroniques 571,573 dissipent en fonctionnement plus de chaleur que les premier et troisième composants électroniques 570,572.

Le premier caloduc 510 et le deuxième caloduc 511 se présentent sous la forme d'un tube fermé de section circulaire, par exemple en cuivre, dans lequel un fluide caloporteur circule. De façon connu, le premier caloduc 510 et le deuxième caloduc 511 comprennent chacun une première extrémité où le fluide se vaporise en absorbant de l'énergie thermique et une deuxième extrémité où le fluide se condense pour retourner à l'état liquide, la circulation du fluide au sein du premier caloduc 510 et du deuxième caloduc 511 se faisant par exemple par capillarité.

Dans l'exemple décrit, le boitier 560 est un parallélépipède rectangle comprenant un fond 561 entouré d'une première 563, d'une deuxième 562, d'une troisième et d'une quatrième paroi. La longueur de la première et deuxième paroi définit la largeur du boitier, et la longueur de la troisième et quatrième paroi définit la longueur du boitier. Le fond 561 et les quatre parois du boitier 561 définissent en outre un logement intérieur du boitier.

Dans l'exemple décrit, le boitier 560 est un boitier métallique, par exemple en aluminium.

Dans l'exemple décrit ici, le fond 561 comprend, sur sa face intérieure au boitier 560 et par rapport au reste de la surface sensiblement plane du fond 561, une excroissance de forme parallélépipédique qui s'étend entre la première 563 et la deuxième paroi 562 du boitier 560. Le boitier 560 comprend en outre un premier conduit 530. Le premier conduit 530 comprend une cavité 580 formée dans la face extérieure du fond 561 de sorte que ladite cavité 580 soit au moins en partie comprise dans ladite excroissance. Ainsi, l'intérieur du premier conduit 530 est délimité par l'intérieur de la cavité 580. Cette cavité est par exemple usinée à partir de l'extérieur du fond 561.

Dans l'exemple décrit ici, l'intérieur du premier conduit 530 débouche sur l'extérieur du boitier 560 au niveau de la première et de la deuxième paroi 563,562. En d'autres termes, les première et deuxième parois 563 comprennent une ouverture qui se trouve placée en vis-à-vis de l'intérieur du premier conduit 530.

Dans l'exemple décrit ici, l'intérieur du premier conduit 530 à une forme tubulaire creuse dont la forme de la section correspond à une demi-ellipse. En variante, la section de la forme tubulaire creuse peut être sensiblement rectangulaire.

En outre, la section de la forme tubulaire creuse est suffisamment importante pour permettre l'introduction en son sein de la première extrémité du premier et du deuxième caloduc 510,511.

En outre, dans l'exemple décrit ici, le premier conduit 530 présente trois faces rectangulaires extérieures 531, 532, 533 accessibles depuis le logement intérieur du boitier 560. Les deux faces rectangulaires 531, 533 sont parallèles à la troisième et à la quatrième paroi du boitier 560 tandis que la face rectangulaire 532 est parallèle au fond 561 du boitier 560. En variante, le premier conduit 530 peut présenter seulement deux faces extérieures, voire une seule face extérieure, accessibles depuis le logement intérieur du boitier 560.

Les trois faces rectangulaires 531, 532, 533 présentent des zones de réceptions 550₁, 550₂, 550₃, 550₄, 551₁, 551₂, 551₃, 551₄, 552₁, 552₂, 552₃, 552₄ en contact thermique avec des composants électroniques du convertisseur de tension 500.

Les zones de réception 551₁, 551₂, 551₃, 551₄, 552₁, 552₂, 552₃, 552₄ sont constitué de cavités de réception de composants électroniques, chacune desdites cavités étant réalisées dans une excroissance faisant saillie à partir des faces rectangulaires 531, 533 du premier conduit 530.

Dans l'exemple décrit ici, les ouvertures des cavités des zones de réception 551₁, 551₂, 551₃, 551₄, 552₁, 552₂, 552₃, 552₄ sont parallèles au fond 561 du boitier 560.

Les zones de réception 550₁, 550₂, 550₃, 550₄ font partie de la surface extérieure de la face rectangulaire 532.

Dans l'exemple décrit ici, le premier composant électronique 570 est placé en contact de la zone de réception 550₃ par l'intermédiaire d'une pâte thermique et le deuxième composant électronique 571 est placé en contact de la zone de réception 551₁ par l'intermédiaire d'une pâte thermique. En outre, le troisième composant électronique 572 est placé en contact de la zone de réception 550₂ par l'intermédiaire d'une pâte thermique et le quatrième composant électronique 573 est inséré dans la cavité de la zone de réception 551₄, le contact entre le quatrième composant électronique 573 et une partie de ladite cavité s'effectuant également au moyen d'une pâte thermique.

Le premier radiateur 540 est composé d'un empilage d'ailettes métalliques de forme rectangulaire. Les ailettes métalliques sont séparées par un espace pour permettre le passage d'un flux d'air entre elles.

Le premier radiateur 540 et le premier ventilateur 520 sont fixés à l'extérieur du boitier 560, i.e. à l'extérieur du logement intérieur du boitier 560, sur la première paroi 563. Le premier ventilateur 520 est en outre fixé sur la première paroi 563 de façon à refroidir le premier radiateur 540. En d'autres termes, Le premier ventilateur 520 et le premier radiateur 540 sont fixés sur la première paroi 563 de sorte que les ailettes métalliques du premier radiateur 540 soient parallèles à la première paroi 563 et que le premier ventilateur, lorsqu'il est en fonctionnement, génère un flux d'air passant entre lesdites ailettes métalliques permettant ainsi leur refroidissement.

Le deuxième radiateur 541 est composé d'un empilage d'ailettes métalliques de forme rectangulaire. Les ailettes métalliques sont séparées par un espace pour permettre le passage d'un flux d'air entre elles.

Le deuxième radiateur 541 et le deuxième ventilateur 521 sont fixés à l'extérieur du boitier 560, i.e. à l'extérieur du logement intérieur du boitier 560, sur la deuxième paroi 562. Le deuxième ventilateur 521 est en outre fixé sur la deuxième paroi 562 de façon à refroidir le deuxième radiateur 541. En d'autres termes, Le deuxième ventilateur 521 et le deuxième radiateur 541 sont fixés sur la deuxième paroi 562 de sorte que les ailettes métalliques du deuxième radiateur 541 soient parallèles à la deuxième paroi 562 et que le deuxième ventilateur521, lorsqu'il est en fonctionnement, génère un flux d'air passant entre lesdites ailettes métalliques permettant ainsi leur refroidissement.

Dans l'exemple décrit ici, les premier et le deuxième ventilateur 520,521 sont des ventilateurs axiaux. En variante, les premier et deuxième ventilateurs 520,521 peuvent être des ventilateurs radiaux ou tangentiels.

En outre, chacune des ailettes métalliques du premier et du deuxième radiateur 540,541 comprennent une ouverture, ces ouvertures étant suffisamment larges et positionnées en regard les unes des autres de façon à permettre l'introduction, depuis l'extérieur du boitier 560, d'une extrémité du premier et du deuxième caloduc 510,511 dans la section de forme tubulaire creuse du premier conduit 530.

Ainsi le premier caloduc 510 traverse, avant son introduction dans la section de forme tubulaire creuse du premier conduit 530, les ailettes métalliques du premier radiateur 540 et la première paroi 563 du boitier 560, le deuxième caloduc 511 traverse, avant son introduction dans la section de forme tubulaire creuse du premier conduit 530, les ailettes métalliques du deuxième radiateur 541 et la deuxième paroi 562 du boitier 560.

Dans ce cinquième mode de réalisation de l'invention, le premier caloduc 510 est disposé dans le premier conduit 530 de sorte que sa première extrémité est en contact thermique avec les zones de réception 550₃, 550₄, 551₁, 551₂, 552₁, 552₂ et de sorte que sa deuxième extrémité est en contact thermique avec les ailettes métalliques du premier radiateur 540. Ainsi, dans ce deuxième mode de réalisation de l'invention, le premier caloduc 510 pénètre seulement jusqu'à la moitié du premier conduit 530.

Le premier caloduc 510 peut optionnellement être fixé au premier radiateur 540 par sertissage.

Après son introduction, le deuxième caloduc 511 est disposé au moins partiellement dans le premier conduit 530 de sorte que sa première extrémité est en contact thermique avec les zones de réception 550₁, 550₂, 551₃, 551₄, 552₃, 552₄ et de sorte que sa deuxième extrémité est en contact thermique avec les ailettes métalliques du deuxième radiateur 541. Ainsi, dans ce deuxième mode de réalisation de l'invention, le deuxième caloduc 511 pénètre seulement jusqu'à la moitié du premier conduit 530.

Le deuxième caloduc 511 peut optionnellement être fixé au deuxième radiateur 541 par sertissage.

Lorsque le convertisseur de tension 500 est en marche, les premier et deuxième composants électroniques 570, 571 s'échauffent et leur température augmente. L'énergie thermique dissipée par les premier et deuxième composants électroniques 570, 571 en fonctionnement est alors drainée vers les zones de réception 550₃, 551₁ du premier conduit 530 par l'intermédiaire de la pâte thermique, puis de ces zones de réception 550₃, 551₁ du premier conduit 530 vers la première extrémité du premier caloduc 510. Au niveau de cette première extrémité, le fluide caloporteur du premier caloduc 510 se vaporise en absorbant l'énergie thermique émise par les premier et deuxième composants électroniques 570, 571. La vapeur circule alors dans le premier caloduc 510 jusqu'à sa deuxième extrémité située au niveau des ailettes métalliques du premier radiateur 540 où elle se condense pour retourner à l'état liquide. Durant la phase de condensation l'énergie thermique est transmise du premier caloduc 510 au premier radiateur 540 refroidi par le premier ventilateur 520.

De même, lorsque le convertisseur de tension 500 est en marche, les troisième et quatrième composants électroniques 572, 573 s'échauffent et leur température augmente. L'énergie thermique dissipée par les troisième et quatrième composants électroniques 572, 573 en fonctionnement est alors drainée vers les zones de réception 550₂, 551₄ du premier conduit 530 par l'intermédiaire de la pâte thermique, puis de ces zones de réception 550₂, 551₄ du premier conduit 530 vers la première extrémité du deuxième caloduc 511. Au niveau de cette première extrémité, le fluide caloporteur du deuxième caloduc 511 se vaporise en absorbant l'énergie thermique émise par les troisième et quatrième composants électroniques 572, 573. La vapeur circule alors dans le deuxième caloduc 511 jusqu'à sa deuxième extrémité située au niveau des ailettes métalliques du deuxième radiateur 541 où elle se condense pour retourner à l'état liquide. Durant la phase de condensation l'énergie thermique est transmise du deuxième caloduc 511 au deuxième radiateur 541 refroidi par le deuxième ventilateur 521.

En outre et de façon optionnelle, le boitier 560 peut être hermétiquement clos. Et dans ce cas le boitier 560 comprend un couvercle et des moyens d'étanchéité. Ces moyens d'étanchéité comprennent par exemple un joint d'étanchéité entre le boitier 560 et son couvercle. L'intérieur du boitier 560 et l'intérieur du premier conduit 530 sont hermétiquement séparés, en d'autres termes il n'existe pas d'ouverture dans le premier conduit 530 débouchant sur l'intérieur du boitier 560

Ainsi, le premier caloduc 510 le deuxième caloduc 511, le premier conduit 530, le premier radiateur 540 le deuxième radiateur 541, le premier ventilateur 520 et le deuxième ventilateur 521 constitue un dispositif de refroidissement des premier, deuxième, troisième et quatrième composants électroniques 570,571,572,573.

Dans une première variante du cinquième mode de réalisation de l'invention non représentée sur les figures, le premier conduit 530 présente une première ouverture 558 sur la face rectangulaire 532. La première ouverture 558 est réalisée en lieu et place des zones de réception 550₂ et 550₃. La première ouverture 558 traverse la face rectangulaire 532 du premier conduit 530 et débouche sur l'intérieur du boitier 560. Ainsi, lorsque un composant électronique est introduit au moins partiellement dans la première ouverture 558, ce composant électronique est en contact direct ou seulement par l'intermédiaire d'une pâte thermique avec le premier caloduc 510 et/ou le deuxième caloduc 511. De cette façon, le contact thermique entre ce composant électronique et le premier caloduc 510 et/ou le deuxième caloduc 511 est amélioré puisque ce contact thermique ne se fait plus par l'intermédiaire de la face rectangulaire 532.

En variante, la première ouverture 558 peut également être réalisée dans les face rectangulaires 531, 533 à côté ou en lieu et place des zones de réception 551₁ à 551₄ et 552₁ à 552₄.

Le premier caloduc 510 ou le deuxième caloduc 511 peuvent présenter une section circulaire ou une section semi-circulaire. De façon optionnelle, lorsque le premier caloduc 510 et/ou le deuxième caloduc 511 présentent une section semi circulaire, le premier et/ou le deuxième caloduc 510,511 peuvent comporter une surface plane, qui lorsque les premier et deuxième caloduc 510,511 sont introduits dans le premier conduit 530 est placée en regard de l'intérieur du boitier 560 ce qui permet d'avoir une surface de contact thermique avec le composant électronique introduit dans la première cavité 558 plus importante que lorsque le premier et/ou deuxième caloduc 510,511 présentent une section circulaire.

Dans une deuxième variante du cinquième mode de réalisation de l'invention non représentée sur les figures, le premier conduit 530 présente une première ouverture 558 sur la face rectangulaire 532 qui s'étend de la première paroi 563 à la deuxième paroi 562. Ainsi, la première ouverture 558 est réalisée en lieu et place des zones de réception 550₁, 550₂ 550₃ et 550₄ La première ouverture 558 traverse en outre la face rectangulaire 532 du premier conduit 530 et débouche sur l'intérieur du boitier 560. Ainsi, lorsque le premier et troisième composant électronique 570, 572 sont introduits au moins partiellement dans l'ouverture 558, le premier et troisième composant électronique 570,572 sont en contact direct ou seulement par l'intermédiaire d'une pâte thermique avec le premier et deuxième caloduc 510,511. De cette façon, le contact thermique entre les premier et troisième composant 570,572 et les premier et deuxième caloduc 510,511 est amélioré puisque ce contact thermique ne se fait plus par l'intermédiaire de la face rectangulaire 552.

Le premier caloduc 510 ou le deuxième caloduc 511 peuvent présenter une section circulaire ou une section semi-circulaire. De façon optionnelle, lorsque le premier caloduc 510 et/ou le deuxième caloduc 511 présentent une section semi circulaire, le premier et/ou le deuxième caloduc 510,511 peuvent comporter une surface plane, qui lorsque les premier et deuxième caloduc 510,511 sont introduits dans le premier conduit 530 est placée en regard de l'intérieur du boitier 560 ce qui permet d'avoir une surface de contact thermique avec le premier et/ou le troisième composants électroniques 570,572 plus importante que lorsque le premier et/ou deuxième caloduc 510 présentent une section circulaire.

## Revendications

1. Système électronique (100,200,300,400,500) comportant:
a. un boitier (160,360,460,560) comprenant un fond (161,361,461,561) et au moins une première paroi (163,363,463,563),
b. un premier radiateur (140,340,440,540) fixé à l'extérieur dudit boitier sur ladite première paroi (163,363,463,563), et
c. un premier caloduc (110,310,410,510) destiné à être en contact thermique avec un premier composant électronique, une extrémité dudit premier caloduc (110,310,410,510) traversant ladite première paroi (163,363,463,563) et au moins une partie dudit premier radiateur (140,340,440,540),
ledit système électronique étant **caractérisé en ce qu'**il comprend en outre
a. un premier ventilateur (120,320,420,520) fixé à l'extérieur dudit boitier sur ladite première paroi (163,363,463,563), ledit premier ventilateur (120,320,420,520) étant fixé sur ladite première paroi (163,363,463,563),de façon à refroidir ledit premier radiateur (140,340,440,540),
b. un premier conduit (130,330₁,430,530) compris dans ledit fond ou disposé sur une face intérieure dudit fond,
c. ledit premier caloduc (110,310,410,510) étant au moins partiellement disposé dans ledit premier conduit (130,330₁,430,530).

2. Système électronique (100,200,300,400,500) selon la revendication précédente dans lequel ledit premier conduit (130,330₁,430,530) est compris dans ledit fond (161,361,461,561), ledit premier conduit (130,330₁,430,530) comprenant une cavité (480,580) formée sur une face extérieure dudit fond.

3. Système électronique (100,200,300,400,500) selon la revendication 2 dans lequel ladite cavité (480,580) a une forme de rainure.

4. Système électronique (100,200,300,400,500) selon l'une des revendications 1 à 3 dans lequel l'intérieur du premier conduit (130,330₁,430,530) à une forme tubulaire et sa section est de forme circulaire ou de forme sensiblement rectangulaire ou encore de forme au moins partiellement elliptique.

5. Système électronique (100,200,300,400,500) selon les revendications 1 à 4 comprenant en outre ledit premier composant électronique (170), ledit premier composant électronique est en contact thermique avec ledit premier caloduc (110,310,410,510) et ledit premier composant électronique (170) est en outre, par l'intermédiaire d'une pâte thermique électriquement isolante, en contact thermique avec ledit premier conduit (130,330₁,430,530).

6. Système électronique (100,200,300,400,500) selon l'une quelconque des revendications précédentes dans lequel ledit boitier (160,360,460,560) est hermétiquement clôt et dans lequel l'intérieur dudit premier conduit (130,330₁,430,530) est hermétiquement séparé de l'intérieur dudit boitier.

7. Système électronique selon l'une quelconque des revendications 1 à 5 dans lequel ledit premier conduit (130, 330₁, 430, 530) comprend au moins une ouverture (158, 358, 458, 558), ladite ouverture étant réalisée à travers une paroi du premier conduit (130, 330₁, 430, 530), ledit premier composant électronique étant destiné à être au moins partiellement disposé dans ladite au moins une ouverture (158,358; 458; 558) afin d'être en contact thermique directement ou par l'intermédiaire seulement d'une pâte thermique avec le premier caloduc (110, 210, 310, 410, 510).

8. Système électronique (100,200,300,400,500) selon l'une des revendications précédentes dans lequel ledit boitier (160,360,460,560) comprend en outre une deuxième paroi (162,362,462,562), ledit système électronique comprenant en outre :
a. un deuxième radiateur (240,341,541) et un deuxième ventilateur (220,321,521) fixés à l'extérieur dudit boitier sur ladite deuxième paroi, ledit deuxième ventilateur étant fixé sur ladite deuxième paroi de façon à refroidir ledit deuxième radiateur,
b. un deuxième caloduc (210,311,511,521) destiné à être en contact thermique avec un deuxième composant électronique, une extrémité dudit deuxième caloduc (210,311,511,521) traversant ladite deuxième paroi (162,362,462,562) et au moins une partie dudit deuxième radiateur (240,341,541),
c. un deuxième conduit (330₂) compris dans ledit fond (161,361,461,561) ou disposé sur une face extérieure dudit fond
d. ledit deuxième caloduc (210,311,511,521) étant au moins partiellement disposé dans ledit deuxième conduit (330₂).

9. Système électronique (100,200,300,400,500) selon la revendication 8 dans lequel le premier (130,330₁,430,530) et le deuxième conduit (330₂) forme un seul conduit.

10. Système électronique (100,200,300,400,500) selon les revendications 8 à 9 dans lequel le premier (130,330₁,430,530) et/ou le deuxième conduit (330₂) est de forme rectiligne.

11. Système électrique (100,200,300,400,500) selon l'une des revendications précédentes dans lequel ledit premier ventilateur (120,320,420,520) est un ventilateur axial ou un ventilateur radial ou encore un ventilateur tangentiel.

12. Convertisseur de tension comprenant :
a. Un système électronique (100,200,300,400,500) selon les revendications 1 à 11
b. Un interrupteur électronique par exemple un thyristor, une diode un transistor bipolaire, un transistor MOSFET, ou un transistor IGBT ledit premier composant électronique à refroidir étant ledit interrupteur électronique

13. Convertisseur de tension selon la revendication 12 dans lequel ledit convertisseur de tension est un convertisseur de tension continu-continu ou un convertisseur de tension alternative-continu ou encore un convertisseur de tension continu-alternative 1

## Patentansprüche

1. Elektronisches System (100, 200, 300, 400, 500), umfassend:
a. ein Gehäuse (160, 360, 460, 560), das einen Boden (161, 361, 461, 561) und mindestens eine erste Wand (163, 363, 463, 563) aufweist,
b. einen ersten Kühler (140, 340, 440, 540), der an der Außenseite des Gehäuses an der ersten Wand (163, 363, 463, 563) befestigt ist, und
c. ein erstes Wärmerohr (110, 310, 410, 510), das dazu bestimmt ist, in thermischem Kontakt mit einem ersten elektronischen Bauteil zu sein, wobei ein Ende des ersten Wärmerohrs (110, 310, 410, 510) die erste Wand (163, 363, 463, 563) und mindestens einen Teil des ersten Kühlers (140, 340, 440, 540) durchquert,
wobei das elektronische System **dadurch gekennzeichnet ist, dass** es ferner aufweist:
a. einen ersten Ventilator (120, 320, 420, 520), der an der Außenseite des Gehäuses an der ersten Wand (163, 363, 463, 563) befestigt ist, wobei der erste Ventilator (120, 320, 420, 520) an der ersten Wand (163, 363, 463, 563) so befestigt ist, dass er den ersten Kühler (140, 340, 440, 540) kühlt,
b. einen ersten Kanal (130, 330₁, 430, 530), der in dem Boden enthalten ist oder an einer Innenseite des Bodens angeordnet ist,
c. wobei das erste Wärmerohr (110, 310, 410, 510) mindestens teilweise in dem ersten Kanal (130, 330₁, 430, 530) angeordnet ist.

2. Elektronisches System (100, 200, 300, 400, 500) nach dem vorhergehenden Anspruch, wobei der erste Kanal (130, 330₁, 430, 530) in dem Boden (161, 361, 461, 561) enthalten ist, wobei der erste Kanal (130, 330₁, 430, 530) einen Hohlraum (480, 580) aufweist, der an einer Außenseite des Bodens gebildet ist.

3. Elektronisches System (100, 200, 300, 400, 500) nach Anspruch 2, wobei der Hohlraum (480, 580) eine Rinnenform hat.

4. Elektronisches System (100, 200, 300, 400, 500) nach einem der Ansprüche 1 bis 3, wobei der Innenraum des ersten Kanals (130, 330₁, 430, 530) eine Röhrenform hat und sein Querschnitt kreisförmig oder im Wesentlichen rechteckig oder aber mindestens teilweise elliptisch ist.

5. Elektronisches System (100, 200, 300, 400, 500) nach den Ansprüchen 1 bis 4, das ferner das erste elektronische Bauteil (170) aufweist, wobei das erste elektronische Bauteil in thermischem Kontakt mit dem ersten Wärmerohr (110, 310, 410, 510) ist und das erste elektronische Bauteil (170) ferner, über eine elektrisch isolierende Wärmeleitpaste, in thermischem Kontakt mit dem ersten Kanal (130, 330₁, 430, 530) ist.

6. Elektronisches System (100, 200, 300, 400, 500) nach einem der vorhergehenden Ansprüche, wobei das Gehäuse (160, 360, 460, 560) hermetisch abgeschlossen ist und wobei der Innenraum des ersten Kanals (130, 3301, 430, 530) von dem Innenraum des Gehäuses hermetisch getrennt ist.

7. Elektronisches System nach einem der Ansprüche 1 bis 5, wobei der erste Kanal (130, 330₁, 430, 530) mindestens eine Öffnung (158, 358, 458, 558) aufweist, wobei die Öffnung durch eine Wand des ersten Kanals (130, 330₁, 430, 530) hindurch ausgeführt ist, wobei das erste elektronische Bauteil dazu bestimmt ist, mindestens teilweise in der mindestens einen Öffnung (158, 358; 458; 558) angeordnet zu sein, um direkt oder nur über eine Wärmeleitpaste in thermischem Kontakt mit dem ersten Wärmerohr (110, 210, 310, 410, 510) zu sein.

8. Elektronisches System (100, 200, 300, 400, 500) nach einem der vorhergehenden Ansprüche, wobei das Gehäuse (160, 360, 460, 560) ferner eine zweite Wand (162, 362, 462, 562) aufweist, wobei das elektronische System ferner aufweist:
a. einen zweiten Kühler (240, 341, 541) und einen zweiten Ventilator (220, 321, 521), die an der Außenseite des Gehäuses an der zweiten Wand befestigt sind, wobei der zweite Ventilator an der zweiten Wand so befestigt ist, dass er den zweiten Kühler kühlt,
c. ein zweites Wärmerohr (210, 311, 511, 521), das dazu bestimmt ist, in thermischem Kontakt mit einem zweiten elektronischen Bauteil zu sein, wobei ein Ende des zweiten Wärmerohrs (210, 311, 511, 521) die zweite Wand (162, 362, 462, 562) und mindestens einen Teil des zweiten Kühlers (240, 341, 541) durchquert,
c. einen zweiten Kanal (33₀₂), der in dem Boden (161, 361, 461, 561) enthalten ist oder an einer Außenseite des Bodens angeordnet ist
d. wobei das zweite Wärmerohr (210, 311, 511, 521) mindestens teilweise in dem zweiten Kanal (330₃) angeordnet ist.

9. Elektronisches System (100, 200, 300, 400, 500) nach Anspruch 8, wobei der erste (130, 330₁, 430, 530) und der zweite Kanal (330₂) einen einzigen Kanal bilden.

10. Elektronisches System (100, 200, 300, 400, 500) nach den Ansprüchen 8 bis 9, wobei der erste (130, 330₁, 430, 530) und/oder der zweite Kanal (330₂) geradlinig ist.

11. Elektrisches System (100, 200, 300, 400, 500) nach einem der vorhergehenden Ansprüche, wobei der erste Ventilator (120, 320, 420, 520) ein Axialventilator oder ein Radialventilator oder aber ein Tangentialventilator ist.

12. Spannungswandler, der aufweist:
a. ein elektronisches System (100, 200, 300, 400, 500) nach den Ansprüchen 1 bis 11,
b. einen elektronischen Schalter, zum Beispiel einen Thyristor, eine Diode, einen Bipolartransistor, einen MOSFET-Transistor oder einen IGBT-Transistor, wobei das zu kühlende erste elektronische Bauteil der elektronische Schalter ist.

13. Spannungswandler nach Anspruch 12, wobei der Spannungswandler ein Gleichspannungs-GleichspannungsWandler oder ein Wechselspannungs-GleichspannungsWandler oder aber ein Gleichspannungs-Wechselspannungs-Wandler ist.

## Claims

1. Electronic system (100, 200, 300, 400, 500) comprising:
a. a housing (160, 360, 460, 560) comprising a bottom (161, 361, 461, 561) and at least one first wall (163, 363, 463, 563),
b. a first radiator (140, 340, 440, 540) secured on the outside of said housing on said first wall (163, 363, 463, 563), and
c. a first heat pipe (110, 310, 410, 510) intended to be in thermal contact with a first electronic component, one end of said first heat pipe (110, 310, 410, 510) passing through said first wall (163, 363, 463, 563) and at least part of said first radiator (140, 340, 440, 540),
said electronic system being **characterized in that** it further comprises
a. a first fan (120, 320, 420, 520) secured on the outside of said housing on said first wall (163, 363, 463, 563), said first fan (120, 320, 420, 520) being secured to said first wall (163, 363, 463, 563) in such a way as to cool said first radiator (140, 340, 440, 540),
b. a first duct (130, 330₁, 430, 530) included in said bottom or arranged on an inner face of said bottom,
c. said first heat pipe (110, 310, 410, 510) being arranged at least partially in said first duct (130, 330₁, 430, 530) .

2. Electronic system (100, 200, 300, 400, 500) according to the preceding claim, wherein said first duct (130, 330₁, 430, 530) is included in said bottom (161, 361, 461, 561), said first duct (130, 330₁, 430, 530) comprising a cavity (480, 580) formed on an outer face of said bottom.

3. Electronic system (100, 200, 300, 400, 500) according to Claim 2, wherein said cavity (480, 580) has a groove shape.

4. Electronic system (100, 200, 300, 400, 500) according to one of Claims 1 to 3, wherein the interior of the first duct (130, 330₁, 430, 530) has a tubular shape and its section is circular or substantially rectangular in shape or at least partially elliptical in shape.

5. Electronic system (100, 200, 300, 400, 500) according to Claims 1 to 4, further comprising said first electronic component (170), said first electronic component is in thermal contact with said first heat pipe (110, 310, 410, 510), and said first electronic component (170) is also, through an electrically insulating thermal paste, in thermal contact with said first duct (130, 330₁, 430, 530).

6. Electronic system (100, 200, 300, 400, 500) according to any one of the preceding claims, wherein said housing (160, 360, 460, 560) is hermetically sealed and wherein the interior of said first duct (130, 330₁, 430, 530) is hermetically separated from the interior of said housing.

7. Electronic system according to any one of Claims 1 to 5, wherein said first duct (130, 330₁, 430, 530) comprises at least one opening (158, 358, 458, 558), said opening being made through a wall of the first duct (130, 330₁, 430, 530), said first electronic component being intended to be arranged at least partially in said at least one opening (158, 358; 458; 558) in order to be in thermal contact, directly or only through a thermal paste, with the first heat pipe (110, 210, 310, 410, 510) .

8. Electronic system (100, 200, 300, 400, 500) according to one of the preceding claims, wherein said housing (160, 360, 460, 560) further comprises a second wall (162, 362, 462, 562), said electronic system further comprising:
a. a second radiator (240, 341, 541) and a second fan (220, 321, 521) secured on the outside of said housing on said second wall, said second fan being secured to said second wall in such a way as to cool said second radiator,
b. a second heat pipe (210, 311, 511, 521) intended to be in thermal contact with a second electronic component, one end of said second heat pipe (210, 311, 511, 521) passing through said second wall (162, 362, 462, 562) and at least part of said second radiator (240, 341, 541),
c. a second duct (330₂) included in said bottom (161, 361, 461, 561) or arranged on an outer face of said bottom,
d. said second heat pipe (210, 311, 511, 521) being arranged at least partially in said second duct (330₂).

9. Electronic system (100, 200, 300, 400, 500) according to Claim 8, wherein the first (130, 330₁, 430, 530) and second (330₂) ducts form a single duct.

10. Electronic system (100, 200, 300, 400, 500) according to Claims 8 and 9, wherein the first (130, 330₁, 430, 530) and/or the second (330₂) duct has a rectilinear shape.

11. Electrical system (100, 200, 300, 400, 500) according to one of the preceding claims, wherein said first fan (120, 320, 420, 520) is an axial fan or a radial fan or a tangential fan.

12. Voltage converter comprising:
a. an electronic system (100, 200, 300, 400, 500) according to Claims 1 to 11,
b. an electronic switch, for example a thyristor, a diode, a bipolar transistor, a MOSFET transistor, or an IGBT transistor, said first electronic component to be cooled being said electronic switch.

13. Voltage converter according to Claim 12, wherein said voltage converter is a DC-to-DC voltage converter or an AC-to-DC voltage converter, or a DC-to-AC voltage converter.
